# EUROPÄISCHE PATENTSCHRIFT

(11) **EP 2 476 006 B1**
(45) Veröffentlichungstag und Bekanntmachung des Hinweises auf die Patenterteilung: **16.10.2013**
(21) Anmeldenummer: 10737336.7
(22) Anmeldetag: 02.08.2010
(51) Int. Cl.: G01R 33/12

(54) **VERFAHREN UND VORRICHTUNG ZUR QUALITÄTSKONTROLLE VON SUPRALEITENDEN BÄNDERN**
METHOD AND DEVICE FOR THE QUALITY CONTROL OF SUPERCONDUCTING BANDS
PROCÉDÉ ET DISPOSITIF DE CONTRÔLE DE QUALITÉ DE BANDES SUPRACONDUCTRICES

(30) Priorität: 10.09.2009 DE 102009040808; 15.03.2010 DE 102010011536
(43) Veröffentlichungstag der Anmeldung: 18.07.2012
(73) Patentinhaber: BASF SE, 67056 Ludwigshafen (DE)
(72) Erfinder: BÄCKER, Michael, 50670 Köln (DE); WIEZORECK, Jan, 53117 Bonn (DE)
(86) Internationale Anmeldenummer: PCT/EP2010/061186
(87) Internationale Veröffentlichungsnummer: WO 2011/029669

(56) Entgegenhaltungen:
- EP-A1- 1 972 931
- US-A- 5 223 798
- US-A1- 2006 073 977

## Beschreibung

Die Erfindung betrifft ein Verfahren zur Qualitätskontrolle von supraleitenden Bändern, insbesondere Hochtemperatursupraleiter (HTS)-Bändern, hinsichtlich der kritischen Strombelastbarkeit des Bandes.. Weiterhin betrifft die Erfindung eine Vorrichtung zur Durchführung des genannten Verfahrens.

Der kritischen Transportstrom I_{c} ist eine der wichtigsten Parameter von Hochtemperatursupraleiter-Materialien für industrielle technische Anwendungen. Der kritische Transportstrom gibt hierbei den Maximalstrom an, bei welchem ein elektrisches Bauteil noch supraleitend ist, bei größeren Transportstromstärken bricht die Supraleitung zusammen und aufgrund des dadurch erhöhten elektrischen Widerstands des Stromleitungspfades wird das Bauteil funktionsunfähig, wobei die damit verbundene Wärmeentwicklung auch zu einer Zerstörung des jeweiligen Bauteils führen kann. Daher ist es für den technischen Einsatz von supraleitenden elektrotechnischen Bauteilen oder Komponenten notwendig, dass diese zumindest bei einem in Abhängigkeit von dem jeweiligen Anwendungsfall minimalen kritischen Transportstrom I_{c} (min) supraleitend sind.

Bei der industriellen Herstellung supraleitender Bänder, die also nicht unter Laborbedingungen erfolgt, können in besonderem Maße in dem jeweiligen Band Fehlstellen entstehen, welche den kritischen Transportstrom begrenzen. Diese Fehlstellen können unterschiedlicher Natur sein, beispielsweise bei Herstellung von supraleitenden Bändern durch chemische reaktive Abscheidungen der Materialien durch lokale Unstöchiometrien, durch lokal unvollständige Reaktionen der eingesetzten Precursor, Ungleichmäßigkeiten bei thermischen Zersetzungsreaktionen oder der Temerung der jeweiligen Zwischen- oder Endprodukte, lokalen Defekten beim epitaktischen Aufwachsen des supraleitenden Materials auf dem jeweiligen Substrat und dergleichen. Derartige Fehlstellen können den kritischen Transportstrom derart begrenzen, dass das jeweilige Band für den jeweiligen Anwendungszweck als Ausschuss zu betrachten ist oder aber nur für geringere technische Anforderungen einsetzbar ist. Die Qualitätskontrolle von supraleitenden Bändern ist hierbei besonders dann relevant, wenn diese Bänder für kommerzielle technische Anwendungen eine große Länge aufweisen, beispielsweise zur Herstellung supraleitender Spulen oder elektrischer Versorgungsleitungen, wobei diese Bänder ohne weiteres eine Länge von mehreren hundert Metern oder mehreren Kilometern aufweisen können.

Weiterhin soll das erfindungsgemäße Verfahren dazu geeignet sein, eine Qualitätskontrolle bei großtechnisch hergestellten Supraleiterbändern für technische Anwendungen zu ermöglichen, sodass das Verfahren dazu geeignet ist, die Qualitätskontrolle in einem Herstellungsverfahren von Bändern mit einer Produktionskapazität einer Anlage von mehreren Kilometern Band je Tag zu ermöglichen.

Aus der EP 860 705 B1 sind ein Verfahren und ein Gerät zum Messen des kritischen Stromwertes eines Supraleiterdrahtes bekannt. Der Supraleiterdraht besteht (gedanklich) aus einer Vielzahl von longitudinal angeordneten Drahtabschnitten. Es wird eine Vielzahl von elektrischen Strömen unterschiedlicher Stromstärke vorbestimmt, wobei sich wiederholend jeweils ein Strom einer jeweils gegebenen Stromstärke durch den jeweiligen supraleitend gekühlten Bandabschnitt hindurch geleitet wird und die in dem jeweiligen Drahtabschnitt erzeugte Spannung detektiert wird, bis sämtliche Stromstärken und die resultierenden Spannungen für diesen Bandabschnitt erfasst sind. Diese Messungen erfolgen bei stationär an der Messtrecke angeordnetem Bandabschnitt. Anschließend erfolgt dann ein Vorschub des Bandes um die Länge eines Abschnittes, um den jeweils nachfolgenden Bandabschnitt an der Messtrecke stationär positionieren und durch Aufbringen der Vielzahl von Stromstärken unterschiedlicher Höhe untersuchen zu können. Durch Abtasten des gesamten Bandes, Bandabschnitt für Bandabschnitt, werden dann die Einzelspannungen der Bandabschnitte, die jeweils durch den gleichen elektrischen Strom I(m) erhalten wurden, aufaddiert, um eine Summierungsspannung zu erhalten. Diese Summierungsspannungen werden für jeden elektrischen Strom der Vielzahl unterschiedlicher elektrischer Ströme ermittelt. Anschließend kann dann der kritische Stromwert des supraleitenden Drahtes basierend auf einer Differenzspannung berechnet werden.

Das Verfahren nach der EP 860 705 ist für eine Untersuchung von Supraleiterbändern im Labormaßstab geeignet, nicht jedoch für eine produktionstechnische Qualitätskontrolle, bei welcher die Gesamtproduktionsgeschwindigkeit des Bandes umfassend die Herstellung und die Qualitätskontrolle des jeweiligen Bandes, zumindest im Wesentlichen nicht durch die Qualitätskontrolle beschränkt werden soll. Hierbei kann die Produktionsgeschwindigkeit von Supraleiterbändern beispielsweise durch reaktive chemische Beschichtung mit den entsprechenden Puffer- und Supraleitermaterialien ohne Weiteres Kapazitäten im Bereich von mehreren Kilometern pro Tag je Anlage erreichen. Eine derart hohe Geschwindigkeit bei der Qualitätskontrolle kann durch ein Verfahren nach der EP 860 705 A1 jedoch nicht realisiert werden.

Weiterhin ist es bei einer produktionstechnischen Qualitätskontrolle von Supraleiterbändern gewünscht, die den kritischen Transportstrom begrenzenden Fehlstellen an dem Band möglichst genau zu lokalisieren, um hierdurch das Band ausbessern zu können, beispielsweise durch Aufbringen eines supraleitenden Materials im Bereich der jeweiligen Fehlstelle oder durch andere geeignete Maßnahmen. Dies ist nach dem Verfahren der EP 860 705 A1 jedoch nicht möglich, da hier allenfalls ermittelt werden könnte, ob in einem bestimmten Bandabschnitt eine relevante Fehlstelle vorliegt..Diese Lokalisierung wäre jedoch zu ungenau, da dann die Reparaturmaßnahme den gesamten fehlerbehafteten Bandabschnitt erfassen müsste. Andererseits ist eine genauere Lokalisierung dadurch, dass die Länge der jeweils untersuchten Bandabschnitte verkleinert.wird, in der Praxis nicht möglich, da dann für eine ausreichend genaue Lokalisierung der Fehlstelle die zu untersuchenden Bandabschnitte eine derart geringe Länge aufweisen müssten, dass sich die Untersuchungsdauer des Bandes unakzeptabel verlängern würde.

Die US 6,841,988 B1 beschreibt ein Verfahren und eine Vorrichtung zur Bestimmung der kritischen Stromstärke von supraleitenden Materialien, wobei ein supraleitende Band durch ein variierendes äußeres Magnetfeld transportiert wird. Hierdurch ist eine kontaktlose Messung eines Magnetfeldes möglich, welches durch das externe Magnetfeld in dem Supraleiterband induziert wird. Bei dieser berührungslosen Messung wird das Supraleiterband kontinuierlich durch die Messstrecke transportiert.. Durch ein derartiges Verfahren können zwar gewisse relevante Kenngrö-ßen des Supraleiterbandes ermittelt werden, eine Qualitätskontrolle im Hinblick auf den kritischen Transportstrom des Bandes ist hierdurch jedoch nicht möglich, da die durch das äußere Magnetfeld in dem Band erzeugten Wirbelströme nur sehr indirekt auf Fehlstellen hinweisen. Eine Aussage in Bezug auf die Orientierung der Fehlstellen zur Bandlängsrichtung und damit auch ein eindeutiger Bezug auf eine Begrenzung des kritischen Transportstromes ist hierdurch nicht möglich ist.

Der Erfindung liegt die Aufgabe zugrunde, ein Verfahren zur Qualitätskontrolle von Supraleiterbändern, insbesondere Hochtemperatursupraleiterbändern, in Bezug auf deren technische Einsatzfähigkeit im Hinblick auf den Stromtransport bereitzustellen, welches eine Qualitätsüberwachung in großtechnischen Produktionsverfahren ermöglicht und welches vorzugsweise bei Integration in einen großtechnischen Produktionsprozess die Gesamtproduktionsgeschwindigkeit der Bandherstellung praktisch nicht beschränkt.

Die Aufgabe wird durch ein Verfahren nach Anspruch 1 mit den Merkmalen a) bis e) gelöst sowie durch die Bereitstellung einer Vorrichtung zur Durchführung des Verfahrens nach Anspruch 12. Vorteilhafte Weiterbildungen ergeben sich aus den Unteransprüchen.

Zur Durchführung des erfindungsgemäßen Verfahrens wird der beispielsweise in einer Flüssigstickstoffkühlstrecke supraleitend gekühlte Bandabschnitt mit einer elektrischen Kontaktanordnung umfassend zumindest einen Einspeise- und einen Ableitungskontakt kontaktiert, um zwischen den Kontakten in dem Band einen elektrischen Transportstrom in Bandlängsrichtung zu erzeugen. Der Einspeise- und Ableitungskontakt bilden somit eine Kontaktstrecke aus, in welcher der elektrische Transportstrom durch das Band fließt, wobei der Einspeise- und Ableitungskontakt vom Transportstrom durchflossen sind. Der Transportstrom durch das Band bzw. in dem Band wird somit durch die beiden genannten Kontakte erzeugt oder aufgeprägt. Weiterhin wird innerhalb der Kontaktstrecke und/oder in der Transportstromerzeugungseinrichtung (einschließlich deren Zuleitungen zum Band) eine geeignete Messstrecke angeordnet, mittels derer der Transportstrom oder eine von diesem abgeleitete und/oder abhängige physikalische Messgröße erfassbar ist, die ein Maß für die supraleitenden Transporteigenschaften des Supraleiterbandabschnittes bzw. für den Transportstrom ist. Der Transportstrom kann somit auch die Messstrecke durchfließen. Der Transportstrom wird spannungsgeregelt erzeugt, wobei die den Transportstrom erzeugende Spannung auf einen konstanten Wert oder zeitabhängig geregelt wird. Im Speziellen wird gemäß der Erfindung innerhalb der Kontaktstrecke eine Messstrecke angeordnet, welche durch zwei in Bandlängsrichtung beabstandete, das Band elektrisch kontaktierende elektrische Messkontakte ("innere Spannungskontakte" der Kontaktanordnung) gebildet werden kann. Hierdurch wird zudem eine besonders genaue und reproduzierbare Qualitätsüberwachung ermöglicht, die auch unabhängig von dem Übergangswiderstand der Stromkontakte zur Supraleiterschicht (oder einer auf dieser angeordneten elektrisch leitfähigen Deckschicht) ist. Fehler aufgrund eines Spannungsabfalls an den Stromkontakten zum supraleitend gekühlten Band, die ansonsten ausreichend gering oder vernachlässigbar klein gegenüber dem Spannungsabfall über der Messstrecke sein müssten, werden hierdurch vermieden.

Erfindungsgemäß wird nunmehr das Band (oder allgemein der zu untersuchende Teil des Bandes, dessen Länge ein Vielfaches der Länge des zum jeweiligen Zeitpunkt gekühlten Bandabschnittes beträgt) kontinuierlich durch geeignete Transportmittel in Bandlängsrichtung durch die Messstrecke bewegt. Während der Bewegung des Bandes wird unter elektrischer Kontaktierung des Bandes in diesem ein in Bandlängsrichtung fortschreitender Transportstromes erzeugt, wobei die Kontakte als Einspeise- und Ableitungskontakte dienen. Der erzeugte Transportstrom fließt somit zum jeweiligen Zeitpunkt unidirektional in Bandlängsrichtung und bewirkt einen (rein) ohmschen Spannungsabfall im Band und ist kein Wirbelstrom.

Die Kontaktierung unter Erzeugung des Transportstromes kann kontinuierlich während der Bewegung des zu untersuchenden Teils des Bandes erfolgen, so dass der elektrische Transportstrom kontinuierlich durch das Band oder durch den zu untersuchenden Teil desselben über die Erstreckung des jeweiligen Bandabschnittes hinaus fortschreitet. Während der Bewegung des Bandes können auch die Messkontakte das Band vorzugsweise kontinuierlich kontaktieren. Die Messwerte können kontinuierlich oder schrittweise, d.h. zeitlich getaktet, erfasst werden.

Es versteht sich, dass der zu untersuchende Teilbereich des Bandes praktisch die gesamte Bandlänge umfassen kann, beispielsweise lediglich ausgenommen die endseitigen Bandabschnitte, um beispielsweise das Band an einer Transport- und/oder Aufwickelvorrichtung anzubringen. Der untersuchte Teil des Bandes oder das Band können natürlich ein nicht-ganzzahliges Vielfaches des gekühlten Bandabschnittes sein. Von dem Begriff "Band" sei jeweils der zu untersuchende Teil des Bandes, dessen Länge ein Vielfaches der Länge des zum jeweiligen Zeitpunkt gekühlten Bandabschnittes und/oder der Länge der Kontaktstrecke beträgt, mit umfasst.

Erfindungsgemäß wird weiterhin eine physikalische Messgröße auf Basis der erzeugten Transportstromes in Bezug auf den jeweils momentanen Kontaktabschnitt und/oder Messabschnitt des Bandes erfasst, wobei die physikalische Messgröße derart ausgewählt ist, dass diese ein Maß für die supraleitenden elektrischen Transporteigenschaften (bzw. des Transportstromes) des Bandabschnittes oder eines Teils desselben ist. Bei dem herkömmlichen stromgeregelten besteht bei dem Auftreten von Fehlstellen die Gefahr eines Durchbrennens des supraleitenden Strompfades, so dass hier geeignete Überlastsicherungen vorzusehen sind, die beispielsweise bei Überschreiten eines Maximalwertes des Transportstromes die aufgeprägte Spannung automatisch reduzieren.

Erfindungsgemäß wird eine definierte, beispielsweise konstante oder zeitlich definierte bzw. vorgegebene, Spannung über die Einspeise- und Ableitungskontakte der Kontaktanordnung dem jeweils kontaktierten Bandabschnitt aufgeprägt (der Transportstrom also stromgeregelt erzeugt werden), wobei dann als physikalische Messgröße der resultierende (ohmsche) Transportstrom selber oder eine andere geeignete physikalische Messgröße erfasst wird, welche eine geeignete Korrelation mit dem gemessenen Spannungsabfall oder dem (gemessenen) erzeugten Transportstrom aufweist, wie beispielsweise der elektrische Widerstand oder die elektrische Leitfähigkeit. Dies kann jeweils für eine Stromaufprägung und/oder besonders bevorzugt eine Spannungsaufprägung gelten. Der aufgeprägte oder erzeugte Transportstrom (Sollwert) kann dem minimalen kritischen Transportstrom, dessen Einhaltung über die Bandlänge zu überwachen ist, entsprechen. Bei bekanntem Querschnitt der supraleitenden Schicht des Bandes kann jeweils auch die kritische Stromdichte anstelle der kritischen Stromstärke herangezogen werden. Besonderer Vorteil einer spannungsgeregelten Messung gegenüber einer Messung mit vorgegebenem Transportstrom ist zum Einen, dass ein Durchbrennen des Leiters bei Fehlstellen sicher vermieden wird. Weiterhin ist es bei einer spannungsgeregelten Messung nicht erforderlich, den Leiter während der Messung mit einem elektrischen Shunt (d.h. einer ausreichend dicken niederohmigen Schutzschicht, welche einen elektrischen Strom von dem Supraleitermaterial, welches nicht mehr in supraleitendem Zustand ist, zu einer Senke bzw. Erdung hin ableitet) zu versehen. Das erfindungsgemäße Verfahren betrifft daher auch die Qualitätskontrolle von supraleitenden Bändern, welche nicht mit einem elektrischen Shunt versehen sind, insbesondere auch von supraleitenden Bändern zur Herstellung von Strombegrenzern (FCL). Weiterer Vorteil des erfindungsgemäßen Verfahrens ist, dass die Messung des Transportstromes oder der von diesem abhängigen Größe nicht unter Anwendung eines vergleichsweise hohen externen Magnetfeldes erfolgen muss. So kann prinzipiell bei Messungen mit konstantem Strom der kritische Strom des Supraleiters durch das Anlegen eines externen Magnetfeldes so stark verringert werden, dass der Messstrom auch bei Überschreitung des kritischen Stromes nicht ausreicht, um ein Durchbrennen des Leiters zu verursachen. Es ist dann jedoch in der Regel ein relativ starkes externes Magnetfeld erforderlich, beispielsweise von 0,6 T (Tesla). Zum Einen sind jedoch die Eigenschaften des supraleitenden Materials bei einem derart starken externen Magnetfeld für viele Anwendungen nicht relevant, zum Anderen werden bei derart starken Magnetfeldern insbesondere bei ferri- oder ferromagnetischen Substraten und insbesondere bei kontinuierlicher Messung sehr hohe Kräfte auf das Band ausgeübt, welche eine aufwändige Bandführung durch das externe Magnetfeld bedingen. Weiterhin muss bei breiten Bändern auch das Magnetfeld über die gesamte Bandbreite sehr homogen sein. Sämtliche dieser Nachteile sind bei dem erfindungsgemäßen Verfahren nicht gegeben. Die Erfindung betrifft somit auch ein Verfahren zur Qualitätskontrolle von supraleitenden Bändern auf einem ferrimagnetischen und/oder ferromagnetischen Substrat, z.B. einer Ni-Legierung, wobei zwischen dem Substrat und der supraleitenden Schicht weitere Schichten wie z.B. Pufferschichten vorgesehen sein können, welche aus oxidischen Materialien bestehen können. Durch das erfindungsgemäße Verfahren können somit Bänder mit einer Breite von ≥ 1-2 cm oder ≥ 5-7 cm oder ≥ 9-11 cm untersucht werden, die Bandbreite kann ≤ 13-15 cm oder ≤ 9-11 cm sein.

Allgemein erfolgt im Rahmen der Erfindung die Erzeugung des Transportstromes jeweils spannungsgeregelt, wobei der resultierende (idealisierte) Transportstrom konstant oder zeitabhängig sein kann. Die Spannung kann auf einen konstanten oder einen zeitabhängigen Wert geregelt werden. Die Ausführungen zu einem zeitabhängigen Transportstrom (z.B. Transportwechselstrom) beziehen sich auf einen idealisierten Transportstrom (d.h. ohne Unregelmäßigkeiten aufgrund von Unregelmäßigkeiten des Supraleitermaterials) und können dann im Rahmen der Erfindung jeweils unmittelbar auch für die diesen erzeugende Spannung gelten, wie z.B. bezüglich des Zeitabhängigkeitsprofils (sinus-, sägezahnförmig etc), Frequenzen usw. Alternativ können sich die Ausführungen jeweils auch auf den geregelten Transportstrom beziehen, wobei dann z.B. der Spannungsabfall die Messgröße sein kann.

Durch das erfindungsgemäße Verfahren ist es somit möglich, das Supraleiterband (oder ein Teil desselben) kontinuierlich in dem jeweiligen Produktionsverfahren dahingehend zu überprüfen, dass die gestellten Erfordernisse im Hinblick auf den zu realisierenden minimalen kritischen Transportstrom erfüllt werden. Diese Überprüfung kann in dem jeweiligen Produktionsverfahren integriert erfolgen, so dass das erfindungsgemäße Verfahren (bzw. Vorrichtung) unmittelbar Teil eines kontinuierlichen Produktionsverfahrens (oder Anlage) des Bandes ist, oder gegebenenfalls unabhängig von diesem mit zumindest im Wesentlichen derselben oder höherer Geschwindigkeit (bezogen auf Bandlänge je Zeit) wie die Produktionsanlage betrieben werden kann, beispielsweise auch im Batchbetrieb. Hierzu kann beispielsweise ein Band einer bestimmten Länge aufgespult und die Bandspule dann zu einem späteren Zeitpunkt dem erfindungsgemäßen Verfahren unterworfen wird. Es ist somit nicht mehr erforderlich, wie z.B. nach der EP 860 705 A1, einen jeweiligen Bandabschnitt bei stationär angeordnetem Band zu untersuchen, den in Bandlängsrichtung nachfolgenden Bandabschnitt an der Messstrecke zu positionieren und diesen wiederum unter stationärer Positionierung an der Messstrecke im Hinblick auf seine Strom-Spannungs-Charakteristik zu untersuchen. Das erfindungsgemäße Verfahren ist somit wesentlich schneller durchführbar. Weiterhin kann das Band während der Erfassung der physikalischen Messgröße kontinuierlich weiterbewegt werden, so dass positive oder negative Beschleunigungen des Bandes, wie sie bei stationärer Messung notwendig sind, minimiert oder vollständig entbehrlich sind, wodurch auch mechanische Beanspruchungen des Bandes, die zu Defekten des Bandes führen können, vermieden werden.

Weiterhin ist es nach dem erfindungsgemäßen Verfahren nur noch notwendig, zu überwachen, ob der vorgegebene minimale kritische Transportstrom Ic(min) über die gesamte Bandlänge (bzw. den zu kontrollierenden Teil des Bandes) eingehalten wird, wobei die Aufnahme einer vollständigen Strom-Spannungs-Charakteristik der jeweiligen Bandabschnitte oder des gesamten Bandes nicht notwendig ist. Besonderer Vorteil der spannungsgeregelten Messung ist hierbei, dass für jede Messstelle, d.h. jeden zu messenden Bereich des Bandes nur ein Messdurchlauf erforderlich ist, um den wirklichen kritischen Strom Ic zu ermitteln.

Vorteilhafterweise wird über die Kontaktstrecke (d.h. zwischen Einspeise- und Ableitungskontakt) ein als minimaler kritischer Transportstrom definierter Strom Ic (min) als Dauerstrom in das Band eingespeist, so dass über die Messstrecke nur der Spannungsabfall oder eine von diesem abgeleitete physikalische Größe gemessen wird, um festzustellen, ob über die Kontakt- und/oder Messstrecke das Kriterium für Supraleitung ausreichend eingehalten wird. Der Strom Ic(min) kann also die Höhe des kritischen Transportstroms haben, den das untersuchte gemäß Anforderungsprofil haben soll. Der eingespeiste Strom kann allgemein im Rahmen der Erfindung derart gewählt sein, dass der Spannungsabfall über die Kontaktstrecke im Bereich von 0 oder 0,001 oder 0,01 bis 25 µV/cm, 0,05 bis 10 µV/cm oder 0,1 bis 5 µV/cm oder im Bereich von 0,5 bis 3 liegt oder ca. 1 µV/cm beträgt.

Das erfindungsgemäße Verfahren kann allgemein derart durchgeführt werden, dass ein derartiger elektrischer Transportstrom erzeugt wird, welcher in dem supraleitenden Bandabschnitt an der Messstrecke kleiner/gleich eines vorgegebenen Sollwertes ist, welcher für den jeweiligen Anwendungsfall eine ausreichend hohe kritische Stromstärke bedeutet, beispielsweise ein Spannungsabfall von bis zu 5 bis 10 µV/cm, vorzugsweise von bis zu 1-2 µV/cm oder von bis zu 0,5 - 0,75 µV/cm oder von bis zu 0,1 - 0,2 µV/cm. Im erfindungsgemäßen Verfahren kann das Band mit einer Bandgeschwindigkeit von ca. 0,5 - 50 m/sec durch die Messstrecke bewegt werden, gegebenenfalls auch mit geringerer oder größerer Geschwindigkeit.

Die Qualitätskontrolle des gesamten Bandes (zumindest ab einem Referenzpunkt) oder des zu untersuchenden Teils, insbesondere also auch der Durchlauf durch die Kontaktierungs- und/oder Messtrecke, kann bei einer konstanten Transportgeschwindigkeit des Bandes erfolgen, die z.B. ≤ ± 30-50%, ≤ ± 10-20% oder ≤ ± 3-5% von der mittleren Bandgeschwindigkeit abweichen kann. Vorzugsweise wird die Bandgeschwindigkeit während der Durchführung des Verfahrens zumindest ab einem vordefinierten Referenzpunkt erfasst oder gemessen, vorzugsweise zeitabhängig über die Verfahrensdauer, und/oder die Durchlaufzeit des Bandes ab einem vorbestimmten Referenzpunkt des Bandes, ab dem die Kontrolle erfolgt. Hierdurch kann das Verfahren derart durchgeführt werden, dass die Positionierung der Kontakt- und/oder Messstrecke zu dem jeweiligen lokalen Bandabschnitt auch nach Abschluss der Untersuchung stets nachvollziehbar ist.

Vorzugsweise wird die physikalische Messgröße kontinuierlich während der Bewegung des Bandes erfasst, insbesondere über eine Bewegung des Bandes, die ein Vielfaches der Bandabschnittslänge beträgt. Das erfindungsgemäße Verfahren ist prinzipiell nicht auf bestimmte Bandlängen beschränkt, die Länge eines einzelnen Bandes kann somit ohne Weiteres ≥ 200-500 m, ≥ 1.000-2.000 m oder ≥ 5.000 m betragen, ohne hierauf beschränkt zu sein. Die Bandlänge (oder untersuchte Teillänge) kann somit ≥ die 100-fache oder ≥ 200-500-fache oder ≥ 1000-5000-fache Länge des gekühlten Bandabschnittes betragen. Durch das erfindungsgemäße Verfahren kann ein Durchsatz von mehr als 1-5 Kilometer Bandlänge je Tag (km/d), ohne Weiteres aber auch ≥ 5-20 km/d oder ≥ 20-50 km/d, ohne Weiteres bis zu 50-100 km/d oder darüber hinaus erzielt werden, der Durchsatz kann hierbei der Bandgeschwindigkeit entsprechen. Die Bandgeschwindigkeit durch die Messstrecke kann z.B. ca. 0,1 m/sec bis ca. 50 m/sec betragen.

Weiterhin ist durch das erfindungsgemäße Verfahren zugleich eine einfache und schnelle Detektierung und/oder örtliche Lokalisierung der den kritischen Transportstrom Ic begrenzenden (bzw. zu einer Unterschreitung des geforderten minimalen Transportstromes Ic(min) führenden) Fehlstellen des Bandes oder des untersuchten Teils desselben möglich, wobei die Ortauflösung der Lokalisierung der Fehlstellen größer als die Länge oder ¼ bis ½ oder 1/8 bis 1/16 der Länge der Kontaktstrecke ist (bei mehreren Einspeise- und/oder Ableitungskontakten zur Erzeugung des (mittelbar) zu messenden Transportstromes einschließlich sämtlicher Kontakte oder ggf. engster Abstand der Einspeise- und Ableitungskontakte). Dann, wenn die jeweilige Fehlstelle durch den Bandtransport in die Kontaktstrecke und/oder die Messstrecke eintritt, ändert sich die jeweilige physikalische Messgröße signifikant, beispielsweise erfolgt ein drastischer Spannungsanstieg oder Abfall des Transportstromes, gegebenenfalls bis zum Zusammenbrechen der Supraleitung. Der Bandabschnitt im Bereich der lokalen Fehlstelle kann dann durch geeignete Mittel unmittelbar markiert werden oder es kann bei bekannter Transportgeschwindigkeit des Bandes nach Untersuchung des gesamten Bandes der fehlerbehaftete Bandabschnitt lokalisiert werden, wenn beispielsweise die physikalische Messgröße zeitabhängig erfasst wird (bei sich ändernder Bandtransportgeschwindigkeit ist dann auch die Zeitabhängigkeit der Bandgeschwindigkeit zu erfassen). Es kann dann zielgerichtet lokal der fehlerbehaftete Bandabschnitt ausgebessert werden, um den geforderten kritischen Transportstrom über die gesamte Bandlänge einhalten zu können. Nach dem Verfahren der EP 860 705 A1 ist demgegenüber lediglich feststellbar, ob ein gegebener Bandabschnitt fehlerbehaftet ist. Da dieser Bandabschnitt jedoch eine möglichst große Länge aufweisen muss, um die Anzahl an Einzelmessungen zu minimieren, so dass das Verfahren bei großen Bandlängen überhaupt noch praktikabel ist, müsste praktisch der gesamte Bandabschnitt aus dem Band herausgetrennt oder überbrückt werden, was jedoch sehr nachteilig ist.

Die physikalische Messgröße wird vorzugsweise kontinuierlich während der Bewegung des Bandes unter der Kontakt- und/oder Messstrecke erfasst, so dass der gesamte zu.untersuchende Teilbereich des Bandes oder das gesamte Band ohne Bandstillstand durch die Kontakt- und/oder Messstrecke durchgeführt wird und die Messgröße erfasst wird. Die physikalische Messgröße kann hierbei gegebenenfalls auch zeitgetaktet erfasst werden. Die Zeittaktung ist auch in Abhängigkeit von der gewünschten Ortsauflösung zur Lokalisierung der den kritischen Transportstrom begrenzenden lokalen Fehlstellen zu bestimmen und/oder kann zur Ortsauflösung herangezogen werden. Die Zeittaktung kann derart gewählt sein, dass der zeitliche Abstand zwischen zwei Messereignissen aufeinander folgender Teilbereiche des Bandes, kleiner ist als Quotient aus der Länge der Messstrecke und der Bandgeschwindigkeit beim Durchlaufen der Messstrecke. Der Zeitbereich zwischen zwei Messereignissen ohne Erfassung der physikalischen Messgröße kann allgemein <1 oder ≤ ½ bis ¼, ≤ 1/8 bis 1/16, ≤ 1/32 bis 1/64 oder oder ≤ 1/200 bis 1/500 des Quotienten aus Kontaktstrecken- oder Messstreckenlänge und (mittlerer oder bei Messwerterfassung momentaner) Bandgeschwindigkeit betragen. Die Kontakt- oder Messstreckenlänge wird hierbei durch den Abstand der jeweiligen Kontakte in Bandlängsrichtung definiert. Es kann somit eine große Vielzahl an Messungen bei Durchlaufen eines Bandabschnittes durch die Messstrecke erfasst werden, so dass eine entsprechend hohe Ortsauflösung zur Lokalisierung der jeweiligen Fehlstellen erzielt werden kann, wenn die Messgröße mit der Taktanzahl erfasst und ausgewertet wird. Die Messkontakte können hierbei permanent das Band kontaktieren oder gegebenenfalls mit der Zeittaktung in Kontakt mit dem bewegten Band gebracht werden.

Der definierte elektrische Transportstrom, welcher mittels der elektrischen Kontaktanordnung bei kontinuierlich bewegtem Band in das Band eingebracht wird, kann eine konstante Höhe aufweisen, wobei Schwankungen innerhalb gewisser Grenzen wie beispielsweise ≤ ± 10-20, ≤ ± 5-7 oder ≤ ± 2-3% oder ≤ ± 1 des Sollwertes zulässig sein können. Vorzugsweise ist der definierte eingebrachte Strom ein Dauerstrom. Der Dauerstrom kann somit über die Zeitdauer der Durchführung des erfindungsgemäßen Verfahrens an dem jeweiligen Band oder Teil des Bandes nicht unterbrochen werden oder nicht unterhalb des einzuhaltenden minimalen kritischen Transportstromes abfallen.

Der in dem Band erzeugte definierte Transportsstrom kann sich gegebenenfalls auch kontinuierlich zeitlich ändern, beispielsweise über die Zeitdauer, in welcher ein Bandabschnitt mit der Länge der Kontakt- oder Messstrecke jeweils diese durchfährt zunehmend oder abnehmend, die Änderung kann linear oder nichtlinear sein.

Der elektrische Transportstrom in dem gekühlten Bandabschnitt kann in Form eines Wechselstromes erzeugt werden, auf Basis dessen die physikalische Messgröße erfasst wird. Der Wechselstrom kann sich periodisch oder aperiodisch ändern. Wenn nicht anders ausgeführt ist, bezieht sich der Begriff "Transportstrom/Transportwechselstrom" auf den idealisierten Strom, d.h. ohne Berücksichtigung von Unregelmäßigkeiten des Transportstromes aufgrund von Unregelmäßigkeiten des Bandmaterials, insbesondere supraleitenden Materials. Der Wechselstrom (insbesondere auch periodisch oder aperiodisch) wird jeweils besonders bevorzugt durch eine aufgeprägte (geregelte) Wechselspannung erzeugt, welche sich periodisch oder aperiodische ändern kann. Die Ausführungen bezüglich des Transportstromes gelten jeweils auch im Hinblick auf die den Transportstrom erzeugende aufgeprägte Spannung, insbesondere im Hinblick auf die Art der Zeitabhängigkeit (sinus-, sägezahnförmig etc, Frequenz usw.).

Der Wechselstrom kann ein einem Grundstrom, z.B. konstantem oder sich ändernden Grundstrom, überlagerter Wechselstrom in Art einer Stromstärkenmodulation sein, der nicht zu Polaritätsänderungen an den Einspeise-/Ableitungskontakten führen muss (entsprechendes gilt auch für die den Transportstrom erzeugende Wechselspannung). Die Änderung des Transpörtstromes und/oder der geregelten Spannung kann ihrer Art nach allgemein beispielsweise sinusförmig, sägezahnförmig, trapezförmig, dreieck- oder rechteckförmig oder mit anderem geeignetem Profil erfolgen. Die Periode und/oder die Amplitude des Wechselstromes und/oder der Wechselspannung können über den untersuchten Teil des Bandes konstant sein oder sich unabhängig voneinander definiert ändern. Entscheidend ist jeweils, dass die Stromänderung/Spannungsänderung definiert oder bestimmbar ist, z.B. durch geeignete Messung, und vorzugsweise zu einer proportionalen oder allgemein definierten und vorhersehbaren Änderung der physikalischen Messgröße führt, welche mittels der Messstrecke zu erfassen ist, so dass Fehlstellen erfassbar sind. Entsprechendes gilt allgemein auch für andere physikalische Parameter, durch welche in der Messstrecke ein kontinuierlicher Transportstrom erzeugt wird, auf Basis derer die jeweilige physikalische Messgröße erfassbar ist, beispielsweise bei Aufprägen einer Spannung.

Vorzugsweise wird hierbei ein elektrischer Transportwechselstrom (bzw. eine Stromstärkenmodulation) erzeugt, dessen Frequenz (Modulationsfrequenz) größer/gleich dem Quotienten aus (i) der Bandgeschwindigkeit des bewegten Bandes und (ii) der Länge der Kontaktstrecke und/oder Messstrecke bzw. allgemein der Länge des Bandbereiches, über welches die physikalische Messgröße zu einem gegebenen Zeitpunkt bestimmt wird, ist. Entsprechendes gilt vorzugsweise für die aufgeprägte Wechselspannung, durch welche der elektrische Transportstrom erzeugt wird. Für diesen Fall ergibt sich dann (idealerweise) ein korrespondierender Transportwechselstrom, welcher bei Ungleichmäßigkeiten des supraleitenden Materials entsprechenden Schwankungen unterliegt. Die Bandgeschwindigkeit kann die mittlere Bandgeschwindigkeit oder momentane Geschwindigkeit des Bandes bei Durchlaufen der Kontakt- oder Messstrecke sein. Dadurch, dass die Frequenz größer dem genannten Quotienten ist, kann in gewisser Weise eine ortsaufgelöste Charakterisierung des jeweiligen Bandabschnittes im Hinblick auf die Lokalisierung von Fehlstellen und deren Einfluss auf die Transportstrombeschränkung erhalten werden. Andererseits soll die Frequenz nicht zu hoch sein, um etwaige zeitliche Relaxationen in Bezug auf die Erzeugung des elektrischen Transportstromes, etwaige Sekundäreffekte wie beispielsweise unerwünschte Erzeugung von Magnetfeldern oder dergleichen minimieren zu können. Die sich aufgrund des Transportwechselstromes ergebenden Änderungen der physikalischen Messgröße werden an der Messstrecke erfasst.

Die Frequenz des elektrischen Transportwechselstromes bzw. der diesen erzeugenden Wechselspannung kann im Bereich von 0,05 bis 100 Hz, vorzugsweise im Bereich von 0,1 bis 200Hz oder im Bereich von 0,2 bis 100 Hz, besonders bevorzugt im Bereich von 0,5 bis 50 Hz oder im Bereich von 0,5 bis 25 Hz liegen, besonders bevorzugt im Bereich von 1 bis 10 Hz, beispielsweise ca. 5 Hz. Die Frequenz kann auch bis 1.000-2.000 Hz oder bis 5.000 Hz oder mehr betragen, sofern eine Verfälschung der Messergebnisse beispielsweise durch unerwünschte Wirbelströme ausreichend klein ist.

Besonders bevorzugt ist dieser Transportwechselstrom/die aufgrprägte Wechselspannung einem konstanten oder sich zeitabhängig kontinuierlich ändernden Transportstrom (Grundstrom)/Grundspannung überlagert, wobei die physikalische Messgröße auf Basis des resultierenden Überlagerten Transportstromes erfasst wird. Für diesen Fall ist vorzugsweise die Stärke des Grundstromes/Höhe der Spannung größer als die maximale Amplitude des überlagerten Transportwechselstromes/Wechselspannung, so dass keine Umpolungen an den Einspeise- und Ableitungskontakten der Kontaktanordnungen erfolgen. Beispielsweise kann die Amplitude des Transportwechselstromes ≤ 98%, ≤ 80-95% oder ≤ 70-80% oder ≤ 40-60% oder ≤ 10-20% der Stromstärke des konstanten erzeugten Transportstromes betragen, entsprechendes gilt für die Spannungsamplitude/konstante Spannung. Die Erzeugung des jeweiligen Transportstromes kann hierbei ebenfalls entweder stromgeregelt oder aber spannungsgeregelt erfolgen, vorzugsweise entsprechend der Regelung des Grundstromes. Durch die Erzeugung des Transportwechselstromes (gegebenenfalls mit Überlagerung eines Grundstromes), besonders bevorzugt mittels einer geregelten Wechselspannung, kann bei kontinuierlich bewegtem Band eine Art Strom-Spannungs-Charakteristik des jeweiligen Bandabschnittes oder letztlich des Bandes insgesamt erzeugt werden, welche gegenüber der Bestimmung einer Strom-Spannungs-Charakteristik bei stationärem Band aufgrund der Bandgeschwindigkeit bei der Messung zwar eine gewisse Unschärfe aufweist. Dennoch ist es hierdurch möglich, im Rahmen der Qualitätskontrolle lokal spezifischere Angaben zur kritischen Stromstärke des jeweiligen der Strecke zugeordneten Bandabschnittes zu erhalten. So kann hierdurch näherungsweise die Steigung der Strom-Spannungskennlinie eines Bandabschnittes bestimmt werden, das heißt der n-Wert bei Beschreibung der Kennlinie mit einem Potenzgesetz.

Durch die Variation der Stromstärke in dem erwarteten oder zu untersuchenden Bereich der (möglichen) kritischen Stromstärke (vorzugsweise mittels geregelter Spannung) kann so nicht nur der zu erfüllende kritische Minimaltransportstrom kontrolliert werden, sondern es können auch im Rahmen der Amplitudenhöhe des Transportwechselstromes Aussagen über die Einhaltung kritischer Ströme in einem Stromstärkebereich gemacht werden, je nach minimaler und maximaler Stromstärke des Transportwechselstromes.

Erfasst somit eine lokale Fehlstelle eine Stromspitze des Wechselstromes, so wird der Transportstrom auf einen niedrigeren Wert begrenzt, welcher jedoch höher als der minimale kritische Transportstrom sein kann, was zu einer entsprechenden Änderung der erfassten Messgröße führt. Über die ab einem vordefinierten Referenzpunkt des Bandes durchlaufene und erfasste Anzahl an Perioden des Transportwechselstromes ist dann auch eine Ortsbestimmung der lokalen Fehlstelle an dem Band möglich. Hierbei wird davon ausgegangen, dass derartige Fehlstellen, die einen kritischen Transportstrom Ic begrenzen, welcher größer als der minimale kritische Transportstrom des Bandes insgesamt ist, in dem Band letztlich statistisch verteilt angeordnet sind, sowohl was deren örtliche Verteilung über das Band entspricht, als auch der Art der jeweiligen Fehlstellen hinsichtlich deren "Störenergie", also deren Begrenzung der Höhe des kritischen Transportstromes. Es versteht sich hierbei, dass die jeweiligen Fehlstellen mehr oder weniger "starke" oder "schwache" Fehlstellen sein können, welche beispielsweise mehr oder weniger starke Gitterdefekte oder elektronische Defekte in der Hochtemperatursupraleiterschicht bewirken und damit den kritischen Transportstrom mehr oder weniger stark begrenzen können. Hierdurch ist somit auch eine weitergehende Qualitätscharakterisierung des Bandes insgesamt möglich. Weiterhin kann durch die Wahl des Strommusters des erzeugten Wechselstromes die induktive Komponente des am Band gemessenen Spannungsabfalls nach Bedarf verändert werden.

Wird der Transportstrom bzw. die diesen erzeugende Spannung mit einer Wechselstromkomponente (bzw. einer Wechselspannungskomponente) erzeugt, welche mit einem "Grundstrom" konstanter Stromstärke bzw. einer Grundspannung überlagert sein kann, so besteht der am Band gemessene Spannungsabfall aus einer resistiven und einer induktiven Komponente. Die resistive Komponente entsteht durch den Spannungsabfall am Supraleiterband bei Gleichstrom, also dem gewünschten Signal zur Qualitätskontrolle des Bandes. Ein zweiter Anteil des Spannungsabfalls wird von dem sich zeitlich ändernden Strom verursacht, welcher sogenannte AC-Verluste im Band erzeugt. Diese AC-Verluste lassen sich rechnerisch abschätzen, was vor Messbeginn erfolgen kann, wozu die erfindungsgemäße Vorrichtung einen Rechner umfasst. Die Abschätzung kann anhand der Frequenz und Amplitude des erzeugten Wechselstromes und der Eigenschaften des zu untersuchenden supraleitenden Bandes, wie dessen geometrische Abmessungen, Leitfähigkeit, Wechselstromwiderstand usw., erfolgen. Die Messung der physikalischen Messgröße kann im Rahmen der Erfindung derart erfolgen, dass die AC-Verluste keinen wesentlichen Einfluss auf die Ermittlung des lokalen kritischen Stromes Ic (loc) haben. Hierbei sind gegebenenfalls Verfälschungen des wahren kritischen Stromes, welcher bei reinem Gleichstrom des Transportstromes gemessen wird, von ± 20% oder ± 5 - 10% oder ± 1 - 2% akzeptabel. Um die AC-Verluste klein zu halten, können die Amplitude und die Frequenz der Wechselstromkomponente entsprechend niedrig gewählt werden.

Zur möglichst genauen Bestimmung der kritischen Stromstärke Ic (min) mit Wechselstromkomponente bei der Messung können die Messleitungen zum Spannungsabgriff so geführt werden, dass die induktive Messspannung minimiert wird. Hierzu können die elektrischen Verbindungen zwischen dem Einspeise- und Ableitungskontakt der Kontaktanordnung und/oder zwischen den beiden die Messstrecke definierenden Kontakten derart ausgebildet sein, dass diese auf beiden Seiten der Messstrecke gleich starke induzierte Magnetfelder erzeugen. Alternativ oder zusätzlich können eine oder mehrere Kompensationsspulen vorgesehen sein, welche Magnetfelder erzeugen, wobei die Magnetfeldstärke derart eingestellt sein kann, so dass die induktive Komponente des Messsignals minimiert wird. Die Einstellung der Magnetfeldstärke kann empirisch erfolgen, oder rechnerisch.

Alternativ ist es weiterhin möglich, die induktive Komponente des Spannungsabfalls aufgrund des erzeugten Transportwechselstroms rechnerisch zu kompensieren, beispielsweise mit Hilfe der Messung und/oder in Kenntnis der zeitlichen Änderung des Transportstromes dI/dt. Die induktive Komponente des Stromabfalls kann somit rechnerisch von dem Messsignal subtrahiert werden, beispielsweise mit Hilfe eines Mikrokontrollers nach dem Prinzip der Analog- / Digital (AD)-Wandlung.

Vorteilhafterweise ist eine Einrichtung zur Erzeugung eines Magnetfeldes vorgesehen, welches das Supraleiterband im Bereich der Kontakt- und/oder Messstrecke durchdringt, wobei das Magnetfeld quer, vorzugsweise senkrecht, zur Bandlängsrichtung angeordnet ist. Vorzugsweise ist das Magnetfeld quer oder senkrecht, beispielsweise in einem Winkel von 45-135° oder 70-110° oder ca. 90° zu der Bandoberfläche oder Bandlängsrichtung angeordnet. Weist das Band bzw. die Supraleiterschicht eine Hauptebene auf (z.B. parallel zur Bandebene), so ist das Magnetfeld vorzugsweise senkrecht (gegebenenfalls mit den oben genannten Abweichungen von der Normalen) zu der Ebene der Supraleiterschicht angeordnet. Das Magnetfeld ist somit derart relativ zu dem Band im Bereich der Kontakt- und/oder Messstrecke angeordnet, dass durch dieses der Transportstrom auf einen Querschnitt eingeschnürt wird, welcher kleiner als der geometrische Querschnitt der Supraleiterschicht des Bandes ist..Der stromeingeschnürte Bereich bildet dann die eigentliche Messstrecke, da durch diesen der Transportstrom begrenzt wird. Die physikalische Messgröße kann dann im Bereich des Bandes mit eingeschnürtem Transportstromquerschnitt erfasst werden. Durch das äußere Magnetfeld ist somit ein geringerer Transportstrom durch das Band notwendig, um die jeweiligen Informationen in Bezug auf die Qualität oder Eigenschaften der Supraleiterschicht zu erhalten. Der Bereich des (homogenen) Magnetfeldes kann auf die Messstrecke begrenzt sein, vorzugsweise ist die Erstreckung des (homogenen) Magnetfeldes in Bandlängsrichtung kleiner als die Kontakt- und/oder Messstreckenlänge. Die Einspeise-, Ableitungs- und/oder Messkontakte können somit außerhalb des Magnetfeldes angeordnet sein. Das Magnetfeld kann über dessen Erstreckung in Bandlängsrichtung homogen sein. Das Magnetfeld kann sich daher über die Länge der Kontakt- oder Messtrecke erstrecken, aus dem oben genannten Grunde vorzugsweise aber jeweils nur über einen Teil derselben.

Der Transportstrom bzw. kritische Transportstrom kann weiterhin in Abhängigkeit von der Magnetfeldstärke durch die Messanordnung erfasst werden. Um magnetische Wechselfelder zu vermeiden, können hierzu verschiedene Bereiche des gekühlten Bandabschnittes von unterschiedlich starken, vorzugsweise konstanten, Magnetfeldern durchdrungen werden. Hierdurch können weitere wichtige Qualitätskriterien über die Supraleiterschicht gewonnen werden, beispielsweise Aussagen über den Transportstrom in Abhängigkeit von der Feldstärke des externen Magnetfeldes.

Das Magnetfeld kann insbesondere ein stationäres Feld sein. Die Magnetfeldstärke kann im Bereich von 0,001 Tesla bis 10 Tesla liegen (bezogen auf die Komponente senkrecht zum Band, vorzugsweise senkrecht zu der Supraleiterschicht), ohne hierauf beschränkt zu sein, beispielsweise im Bereich von 0,05 bis 1 Tesla oder im Bereich von ca. 0,1 bis 0,2 Tesla oder bis 0,3 oder bis 0,5 Tesla. Insbesondere kann die Magnetfeldstärke im Bereich von beispielsweise 0,001 Tesla bis beispielsweise 0,5 Tesla oder bis 0,4 Tesla liegen, insbesondere ≤ 0,25-0,3 Tesla oder ≤ 0,2-0,15 Tesla sein. Die Magnetfeldstärke kann ≥ 0,001 Tesla oder ≥ 0,005-0,01 Tesla oder ≥ 0,015-0,02 Tesla bzw. ≥ 0,05 Tesla sein. Das Magnetfeld kann jeweils durch einen Permanentmagneten, durch Magnetspulen oder andere geeignete Einrichtungen erzeugt werden.

Insbesondere kann das Verfahren im Übergangsbereich vom supraleitenden in den nicht-supraleitenden (normalleitenden) Zustand des supraleitenden Band durchgeführt werden. Hierzu kann beispielsweise ein sich zeitlich ändernder Transportstrom (Transportwechselstrom) erzeugt werden, dessen Minimalwert im supraleitenden Zustand und dessen Maximalwert im normalleitenden Zustand des supraleitenden Materials oder im Übergangsbereich zwischen diesen liegt. Der Wechselstrom kann insbesondere spannungsgeregelt erzeugt werden, beispielsweise mit einer Wechselspannung, welche z.B. sinusförmig oder ein Sägezahnprofil sein kann. Gegebenenfalls könnte auch das externe Magnetfeld zeitabhängig variert werden, so dass bei niedrigem Magnetfeld der supraleitende Zustand und bei hohem Magnetfeld der normalleitende Zustand bzw. ein Übergangszustand vorliegt. Als "Übergangszustand" sei hier ein solcher mit teilweisem Verlust der Supraleitung verstanden. Eine solche Durchführung ist insbesondere bei Untersuchung von HTC-Bandmaterial für resistive Strombegrenzer und ähnliche Anwendung möglich, diese kann derart durchgeführt werden, dass durch diese die Steilheit bzw. Breite des Supraleiter-Normalleiter-Überganges ermittelbar ist. Die Steilheit Δx/Δy kann beispielsweise angegeben werden durch ein ΔI/Δt bzw. durch ein ΔU/ΔI, wobei Δ die Strom- bzw- Spannungsdifferenz zwischen gerade noch supraleitendem und gerade schon normalleitendem Zustand ist, U ist die den Transportstrom erzeugende Spannung, und t die Zeit, über welche eine Spannungsänderung erfolgt, wobei in beiden Fällen jeweils ΔU/Δt vorzugsweise konstant ist, und wobei I der Transportstrom ist.

Vorzugsweise sind mehrere elektrische Kontakte gleicher Polung als Einspeisekontakte vorgesehen, beispielsweise 2, 3 oder 4 oder mehr, welche gleichzeitig elektrisch kontaktierend an das Band angelegt werden oder anlegbar sind, um zur Erzeugung eines elektrischen Transportstromes in dem Band mehrere Teilströme in das Band einzuspeisen. Hierdurch sind verschiedene Fortbildungen des Verfahrens möglich. Zum Einen können mehrere gleichzeitig an das Band anlegbare Einspeisekontakte, welche das Band während seiner Bewegung in Bandlängsrichtung kontaktieren, einem Ableitungskontakt (oder Gruppe von Ableitungskontakten) zugeordnet sein. Die Messstrecke kann dann zwischen dem dem Ableitungskontakt nächst benachbarten Einspeisekontakt und dem (in Bandtransportrichtung ersten) Ableitungskontakt angeordnet sein. Hierdurch ist der in das Band eingebrachte Transportstrom, auf dessen Basis die physikalische Messgröße erfasst wird, nicht durch den Übergangswiderstand zwischen Einspeisekontakt und Band bei der Bandbewegung oder andere apparative oder verfahrenstechnische Gegebenheiten begrenzt und besonders hohe Bandgeschwindigkeiten bei hohem Transportstrom möglich.

Es können auch zwei oder mehr Kontaktanordnungen vorgesehen sein, die jeweils elektrische Einspeise- und Ableitungskontakte zur Erzeugung jeweils eines unabhängigen elektrischen Transportstromes in dem jeweiligen Bereich des Bandabschnittes und jeweils elektrische Messkontakte unter Ausbildung einer Messstrecke aufweisen. Diese jeweils zwei oder mehr Kontaktanordnungen können gleichzeitig kontaktierend während des Bandtransportes an das Band angelegt werden. Es können hierdurch in verschiedenen Bereichen des gekühlten Bandabschnittes gleichzeitig mehrere unabhängige Transportströme erzeugt werden, wobei die physikalische Messgröße in den verschiedenen Bereichen des Bandabschnittes unter Zuordnung zu den jeweiligen Transportströmen unabhängig voneinander erfasst wird. Die mittels der verschiedenen Kontaktanordnungen in verschiedenen Bereichen des gekühlten Bandes eingebrachten Transportströme können die gleiche Höhe aufweisen, beispielsweise um eine exaktere Qualitätskontrolle zu ermöglichen. Vorzugsweise werden durch die verschiedenen Kontaktanordnungen jeweils Transportströme unterschiedlicher Stromstärke in dem Band erzeugt, auf deren Basis die jeweilige physikalische Messgröße erfasst wird. Hierdurch kann zugleich die Abhängigkeit der jeweiligen physikalischen Messgröße von der Höhe der Transportstromstärke bestimmt werden oder festgestellt werden, ob das Band den Sollwert nicht nur bezüglich einer sondern bezüglich mehrerer unterschiedlicher kritischer Transportstromstärken erfüllt, um somit beispielsweise das Band verschiedenen Qualitäten A, B usw. zuordnen zu können. Die verschiedenen Transportströme können gleichzeitig oder zeitlich unabhängig oder aufeinander folgend in dem jeweiligen gekühlten Bandabschnitt erzeugt werden, so dass ein Transportstrom B erst dann erzeugt wird, wenn ein Transportstrom A mit zugehöriger Erfassung der physikalischen Messgröße bereits unterbrochen oder auf 0 gefahren wurde, um gegenseitige Beeinflussungen der Messströme auszuschließen.

Sind zwei oder mehr Einspeisekontakte vorgesehen, welche einen gewissen Abstand in Bandlängsrichtung zueinander aufweisen, so kann durch diese eine Lokalisierung von den (minimalen) kritischen Transportstrom begrenzenden Fehlstellen durchgeführt werden. Tritt eine Fehlstelle bei Bandtransport in den Bereich zwischen dem ersten und dem zweiten Einspeisekontakt ein, wobei der erste Einspeisekontakt dem Ableitungskontakt am weitesten entfernt ist, so wird der erste Einspeisestrom zur Erzeugung des Tranportstromes und damit der Transportstrom insgesamt unterbrochen oder vermindert. Dies ist bereits in der Messtrecke dieser Kontaktanordnung erfassbar. Die Fehlstelle ist somit zwischen erstem und zweiten Einspeisekontakt lokalisierbar. Tritt die Fehlstelle durch den Bandtransport in den Bereich zwischen zweitem und dritten Einspeisekontakt ein, so wird auch der zweite Einspeisestrom unterbrochen oder vermindert usw. Der Ort der Fehlstelle kann unmittelbar oder in Kenntnis von Messzeitpunkt und Bandgeschwindigkeit an den Band lokalisiert werden. Die mehreren Einspeise- und/oder Ableitungskontakte können jedoch auch unmittelbar aufeinanderfolgend an dem Band angeordnet sein.

Gegebenenfalls kann die jeweilige Kontaktanordnung mehrere Ableitungskontakte aufweisen. Durch diese kann sichergestellt werden, dass der gesamte eingespeiste Strom über die an die supraleitend gekühlten Bandabschnitte angelegten Ableitungskontakte abgeführt wird.

Vorzugsweise beträgt die Bandgeschwindigkeit bei Einspeisung des Transportstromes ca. 0,1 - 20 m/sec, vorzugsweise im Bereich von 0,5 - 10 oder 0,5 - 5 m/sec. Hierdurch ist einerseits eine ausreichend hohe Geschwindigkeit des erfindungsgemäßen Verfahrens insgesamt realisierbar, andererseits werden Kontaktierungsprobleme bei zu hohen Bandgeschwindigkeiten begrenzt.

Das oben genannte Verhältnis der Frequenz des erzeugten Transportwechselstromes zu dem Quotienten aus (i) der Bandgeschwindigkeit des bewegten Bandes und (ii) der Länge der Messtrecke in Bandlängsrichtung, welche jeweils dem gegebenen Bandabschnitt zugeordnet ist, und/oder der Länge der Kontaktstrecke, über welche der Transportstrom erzeugt wird, kann ≥ 1 oder ≥ 1,01-1,05 oder ≥ 1,1, vorzugsweise ≥ 1,5 - 2 oder ≥ 3 - 5 oder besonders bevorzugt ≥ 10 - 15 oder ≥ 20 - 50 betragen, beispielsweise ≤ 100-200 oder ≤ 300-500 oder ≤ 1.000-2.000 oder ≤ 5.000. Hierdurch können induktive Verluste und Verfälschungen der Messergebnisse minimiert werden.

Die die Kontaktstrecke und/oder die Messstrecke ausbildenden Kontakte können einen Abstand im Bereich von 0,2 - 20 m oder 0,5 - 15 m aufweisen, vorzugsweise im Bereich von 1 - 10 m, ohne hierauf beschränkt zu sein. Die Messstreckenlänge kann jedoch gegebenenfalls auch größere oder kleinere Längen aufweisen, zu lange Messstrecken haben den Nachteil, dass damit die Gefahr eines Durchbrennens des Bandes aufgrund vorhandener Fehlstellen steigt. Der Abstand der Einspeise- und Ableitungskontakte ist im Allgemeinen größer als die Länge der Messstrecke, wobei die Messkontakte innerhalb der Kontaktstrecke angeordnet sein können.

Die jeweilige Kontaktanordnung kann in Art einer Vierpunktmessung jeweils einen Einspeise- und einen Ableitungskontakt sowie zwei zwischen diesen angeordnete Messkontakte aufweisen, so dass die beiden Messkontakte nicht stromdurchflossen sind (in Bezug auf die Erzeugung des Transportstromes). Dies kann insbesondere bei Aufprägen einer Spannung und Messung der Stromstärke gelten. Die Kontaktanordnung kann beispielsweise auch in Art einer Dreipunktanordnung ausgebildet sein, so dass einer der beiden Messkontakte zugleich als Einspeisekontakt oder vorzugsweise zugleich als Ableitungskontakt dient. Gegebenenfalls sind auch andere geeignete Kontaktanordnungen einsetzbar.

Bei Detektieren einer den kritischen Transportstrom begrenzenden Fehlstelle kann entweder der die Fehlstelle aufweisende lokale Bandbereich durch geeignete Mittel markiert werden, beispielsweise durch Einkerbung des Bandes oder der Supraleiterschicht. Nach Kontrolle des gesamten Bandes kann dann diese markierte Stelle lokalisiert und ausgebessert werden. Die Markierung kann auch indirekt dadurch erfolgen, dass die Transportgeschwindigkeit des Bandes und die Zeit des Bandvorschubes ausgehend von einem Referenzpunkt kontinuierlich, beispielsweise mit ausreichend enger Zeittaktung, erfasst werden, so dass hierdurch die Fehlstelle nach Durchführung des erfindungsgemäßen Verfahrens wieder lokalisierbar ist. Gegebenenfalls kann die jeweilige lokale Fehlstelle auch unmittelbar nach Detektierung herausgeschnitten werden, bzw. wenn der jeweilige Bandabschnitt die Kühlstrecke verlassen hat, und der Bandtransport kann unterbrochen werden, um den fehlerbehafteten Bandabschnitt zu reparieren oder die Reparatur kann unmittelbar jeweils bei fortlaufendem Bandtransport erfolgen. Zur Reparatur des Bandes kann allgemein die Fehlstelle aus dem Band bzw. der Supraleiterschicht herausgeschnitten werden, wobei die beiden der Fehlstelle benachbarten Bereiche dann über eine niederohmige Verbindung (joint) verbunden werden. Alternativ kann ein neuer Abschnitt an supraleitendem Material auf die Supraleiterschicht aufgebracht werden und diese soweit elektrisch verstärkt werden, so dass die geforderte kritische Stromstärke auch an diesem Abschnitt des Bandes erfüllt wird.

Weiterhin umfasst die Erfindung eine Vorrichtung zur Durchführung des Verfahrens nach Anspruch 1 zur Qualitätskontrolle von Supraleiterbändern, welche insbesondere nach den Ansprüchen 12 bis 24 ausgebildet sein kann.

Besonders bevorzugt sind die Einspeise- und/oder Ableitungskontakte und/oder die Messkontakte der Kontaktanordnung derart ausgebildet, dass diese über einen Längsbereich des Bandes anliegen, welcher jeweils über eine lokale oder punktförmige Kontaktierung hinausgeht. Die Kontakte können hierbei linienförmig (in Bandlängsrichtung) oder flächig an dem Band anliegen. Vorzugsweise sind hierzu die Kontakte in Form von Rollen oder Schleifkontakten ausgebildet, wobei das Band zur Ausbildung von Kontaktbereichen über einen Teilumfang an den Rollen anliegen kann, das Band kann die Kontaktrollen teilumfänglich umschlingen. Hierdurch ist auch bei hohen Bandgeschwindigkeiten ein guter elektrischer Kontakt ausgebildet und Schlupf zwischen dem Band und den Rollen kann vermieden werden. Die Rollen können hierbei entweder eigenständig durch geeignete Antriebsmittel angetrieben werden oder sie werden passiv mit bewegt, wobei das Band durch andere Transportmittel in Bandlängsrichtung transportiert wird, beispielsweise durch eine Auf- und Abwickelspule, die unabhängig voneinander jeweils angetrieben werden können, um das Band durch die Kühlstrecke und die Messstrecke zu transportieren. Gegebenenfalls können auch weitere Transportmittel für das Band, beispielsweise in Form von Transportrollen, vorgesehen sein, wobei das oben Gesagte entsprechend gelten kann. Das Band kann jeweils zwischen zwei gegenüberliegenden Rollen reibschlüssig fortbewegt werden. Das Band kann zwischen gegenüberliegenden Rollen geführt sein, welche an Ober- und Unterseite an dem Band anliegen. Das Band kann hierbei gestreckt oder vorzugsweise bogenförmig oder mäandrierend um die oder zwischen den Rollen geführt sein. Das Band kann jeweils um einen Teilumfang von ≤ 10 - 20°, vorzugsweise ≥ 30 - 45° oder ≥ 60 - 90°, gegebenenfalls auch bis zu 120° oder bis 180° oder mehr an der jeweiligen Rolle anliegen. Gegebenenfalls können die jeweiligen Rollen als Anpressrollen ausgebildet sein und durch geeignete Anpressmittel an das Band angepresst werden, um einen Schlupf des Bandes gegenüber den Rollen zu minimieren. Insbesondere können hierbei mehrere derartige Einspeiserollen oder Einspeisekontakte mit in Bandlängsrichtung linienförmigen oder flächigen Einspeisekontakten vorgesehen sein, die das Band eng und gegebenenfalls ohne Zwischenraum umschließen. Die Achslager der Rollen können jeweils außerhalb der Kühlstrecke angeordnet sein. Zur Erzeugung ist eine regelbare Spannungsquelle vorgesehen, mittels derer der Transportstrom über das Aufbringen einer definierten konstanten oder zeitlich definierten Spannung auf den Bandabschnitt spannungsgeregelt erzeugbar ist.

Allgemein sei ferner angemerkt, dass ein "Supraleiterband" oder "Hochtemperatursupraleiter-Band" im Sinne der Erfindung ein Band mit einer (Hochtemperatur)supraleiterschicht ist, welche auf einem geeigneten Substrat angeordnet sein kann, welches biaxial texturiert sein kann. Das Substrat kann insbesondere ferri- oder ferromagnetisch sein. Zwischen der Supraleiterschicht und dem Substrat können eine oder mehrere Pufferschichten oder andere Zwischenschichten aufgebracht sein, die beispielsweise eine biaxial texturierte Aufwachsung der HTS-Schicht auf dem Substrat ermöglichen und/oder zugleich als Diffusionsbarriere dienen können. Unter einer "Kontaktierung des Bandes" im Sinne der Erfindung ist dann im allgemeinen eine Kontaktierung der in Bandlängsrichtung durchgehenden Supraleiterschicht zu verstehen, falls ein Transportstrom im Supraleiter nicht auch durch Kontaktierung des Substrates erzeugbar ist. Das Substrat ist nicht auf besondere Zusammensetzungen beschränkt, es kann jedoch insbesondere eine Nickellegierung sein, insbesondere eine W-haltige Ni-Legierung, die ≥ 1-2 oder ≥ 5-10 Gew.-W enthalten kann. Das Hochtemperatursupraleitermaterial ist nicht auf bestimmte Materialien begrenzt, diese können insbesondere keramische Supraleiter sein, z.B. vom Y-Ba-Cu- oder Bi-Sr-Ca-Cu- Typ oder dergleichen. Unter Hochtemperatursupraleiter sei hierbei ein Material verstanden, welches eine Sprungtemperatur oberhalb von 77 Kelvin aufweist, das Verfahren ist jedoch nicht auf solche beschränkt. Nach der Qualitätskontrolle kann das Supraleiterband weiteren Produktionsschritten unterworfen werden, beispielsweise einer Anordnung von Deckschichten oder dergleichen. Das erfindungsgemäße Verfahren sowie die Vorrichtung sind insbesondere angepasst, um durch reaktive chemische Abscheidung hergestellte Hochtemperatursupraleitermaterialien untersuchen zu können. Die Supraleiterschichten können jedoch auch auf beliebige andere Weise hergestellt werden, beispielsweise durch Gasphasenabscheidung, Sputtertechniken oder dergleichen. Der Begriff "Band" im Sinne der Erfindung soll nicht auf bestimmte Querschnittsgeometrien beschränkt sein, es können beliebige geeignete Querschnitte vorliegen, wie Drähte oder dergleichen, sofern die Länge des jeweiligen Bandes ein Vielfaches der Breite desselben beträgt.

Die Erfindung wird nachfolgend anhand eines Ausführungsbeispiels beschrieben und erläutert. Es zeigen:
- Figur 1: eine schematische Darstellung einer Vorrichtung zur Durchführung des erfindungsgemäßen Verfahrens,
- Figur 2: eine Kontaktanordnung nach einer Weiterbildung der Vorrichtung nach Figur 1 in Seitenansicht,
- Figur 3: einer Weiterbildung der Vorrichtung nach Figur 1 mit externem Magnetfeld in Seitenansicht,
- Figur 4: Diagramme eines Transportstroms mit jeweils überlagerter sinusförmiger oder sägezahnförmiger Wechselstromkomponente über die Zeit bei Anwesenheit von Fehlstellen in der Supraleiterschicht,
- Figur 5: eine schematische Darstellung einer Kontaktanordnung der erfindungsgemäßen Vorrichtung nach Figur 1 in Draufsicht.

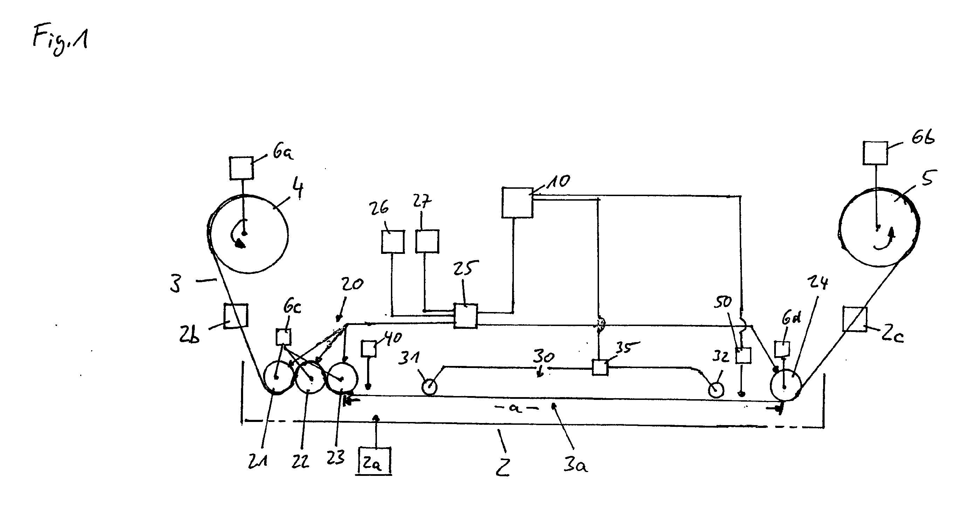

Nach Figur 1 weist die Vorrichtung 1 zur Durchführung des erfindungsgemäßen Verfahrens zur Qualitätskontrolle von (Hochtemperatur)supraleiterbändern eine Kühlstrecke 2 zur Kühlung eines Abschnittes 3a des Bandes 3 auf eine Temperatur, bei welcher dieser Bandabschnitt supraleitend wird, auf. Die Kühlstrecke 2 kann hierzu eine ein geeignetes Kühlmedium wie z.B. flüssigen Stickstoff aufweisen, durch welche das Band durchgeführt werden kann. Die Kühlstrecke kann weiterhin eine Temperaturüberwachungseinrichtung 2a aufweisen, welche die ermittelte Temperatur der Kühlstrecke und/oder des Bandes einer zentralen Kontrolleinrichtung übermittelt. Einrichtungen zum Steuern oder Regeln der Temperaturen eine Solltemperatur können vorgesehen sein. Die Kühlstrecke kann weiterhin eine Vorkühlstrecke 2b aufweisen, so dass das Band bei Abkühlung von Raumtemperatur auf die supraleitende Temperatur vorgekühlt wird, und/oder eine Temperierstrecke 2c, um das Band nach der Kühlung langsamer auf Raumtemperatur erwärmen und jeweils thermisch induzierte Spannungen in dem Band, Kondenswasserabscheidungen und dergleichen vermeiden zu können.

Das in der Vorrichtung angeordnete Supraleiterband 3 kann eine Länge von mehreren 100 Metern aufweisen. Die Länge der Kühlstrecke bzw. die Länge des in der Kühlstrecke supraleitend abgekühlten Bandes kann jeweils beispielsweise im Bereich von 1 bis 10 m liegen. Die genannten Längen sind nicht auf besondere Werte beschränkt. Die Länge des Bandes 3 beträgt hierbei ein Vielfaches der Länge des supraleitend gekühlten Bandabschnittes 3a. Allgemein kann auch ein Bandspeicher vorgesehen sein, um die Anlage kontinuierlich fahren zu können.

Die erfindungsgemäße Vorrichtung kann in einer Anlage zur Herstellung von Supraleiterbändern integriert sein, so dass eine automatische Bandzufuhr aus einem vorgelagerten Anlagenteil vorgesehen ist, wie in Figur 1 dargestellt, kann das Band jedoch auf einer Spule 4 angeordnet sein und nach Durchlaufen der Kühlstrecke von einer Aufwickelspule 5 aufgenommen werden.

Weiterhin weist die Vorrichtung 1 Mittel 6 zur kontinuierlichen Bewegung des Bandes in Bandlängsrichtung (Transportmittel) auf. Diese Mittel 6 können der Kühlstrecke vor- und/oder nachgeordnete Antriebsmittel umfassen, beispielsweise Antriebe 6a, 6b der Abwickel- und Aufwickelspule. Ferner können Antriebsmittel an der Kühlstrecke vorgesehen sein, beispielsweise in Form der Antriebe 6c, d der weiter unten beschriebenen Rollen oder separat vorgesehener Transportrollen. Die Transportmittel sind insgesamt derart ausgebildet, dass mechanische Belastungen, einschließlich Zug- und/oder Stauchbelastungen auf das Band minimiert werden. Durch die Transportmittel kann eine kontinuierliche und gleichmäßige Bewegung des Bandes mit vorzugsweise konstanter Bandgeschwindigkeit durch die Kühlstrecke über die gesamte Bandlänge oder den Untersuchungszeitraum des Bandes erzielt werden, so dass ein Bandstillstand bzw. eine stationäre Anordnung des Bandes an der unten beschriebenen Kontaktstrecke unterbleibt. Die Bandgeschwindigkeit kann beispielsweise ca. 5 m/sec betragen. Die Transportgeschwindigkeit des Bandes, insbesondere innerhalb der Kühlstrecke und/oder der Kontaktstrecke bzw. Messstrecke, kann durch geeignete Mittel geregelt oder gesteuert sein und die tatsächliche Transportgeschwindigkeit kann durch die Kontrolleinrichtung 10 zeitabhängig über dien Untersuchungszeitraum erfasst und gespeichert werden.

Die erfindungsgemäße Vorrichtung umfasst eine Kontaktanordnung 20 mit mehreren elektrischen Kontakten 21 bis 24 zum Kontaktieren des gekühlten Bandabschnittes. Die Kontakte 21 bis 23 dienen hierbei als Einspeisekontakte, der mindestens eine Kontakt 24 als Ableitungskontakt, wobei durch die in Bandlängsrichtung beabstandeten Einspeise- und Ableitungskontakte eine elektrische Kontaktstrecke geschaffen wird, mittels welcher in dem durch diese Kontaktstrecke kontaktierten Bandabschnitt 3c ein elektrischer Transportstrom in Bandlängsrichtung erzeugt wird. Durch die Anordnung mehrerer in Bandlängsrichtung hintereinander angeordneter Einspeisekontakte 21 bis 23 kann auch bei relativ hohen Bandgeschwindigkeiten ein ausreichend hoher Transportstrom in das Band (genauer gesagt die (Hochtemperatur)supraleiterschicht des Bandes) eingebracht werden, um in der Supraleiterschicht eine ausreichend hohe elektrische Stromstärke zu erzeugen, welche im Bereich oder höher als die bezüglich der gestellten Qualitätsanforderungen zu erfüllende minimale kritische Stromstärke Ic (min) ist. Die Einspeise- und Ableitungskontakte (und die unten beschriebenen Messkontakte) können in Form von Rollen ausgebildet sein, welche teilumfänglich und vorzugsweise schlupffrei an dem Band bzw. der Supraleiterschicht anliegen. Es können die Kontakte auch auf andere Weise ausgebildet sein, beispielsweise als Schleifkontakte.

Zwischen den Einspeise- und Ableitungskontakten ist eine Spannungsquelle 25 zur Erzeugung des elektrischen Stromes zwischen den genannten Kontakten vorgesehen, wobei der in dem Band erzeugte Transportstrom mittels der Steuerung/Regelung 26 spannungs- oder stromgeregelt erzeugt werden kann. Weiterhin ist eine Anzeige 27 vorgesehen, um die Stellgröße für den erzeugten Transportstrom (Strom oder Spannung) anzuzeigen, wobei die Werte kontinuierlich, gegebenenfalls mit geeigneten Zeittaktung, die vorzugsweise schnell gegenüber der Bandgeschwindigkeit ist, an die Kontrolleinrichtung 10 übergeben werden können. Der Transportstrom kann kontinuierlich bei bewegtem Band über die Dauer der Anwendung des erfindungsgemäßen Verfahrens bzw. über die gesamte Bandlänge in das Band eingespeist werden.

Weiterhin umfasst die Kontaktanordnung 20 eine Messanordnung 30 umfassend mehrere elektrische Kontakte 31, 32 zum Kontaktieren des gekühlten Bandabschnittes, genauer gesagt der Supraleiterschicht des Bandes, wobei die Kontakte 31, 32 in Bandlängsrichtung voneinander beabstandet sind, um eine Messstrecke über eine Teillänge des Bandes zu bilden. Allgemein kann auch die Supraleiterschicht mit einer leitfähigen Schicht bedeckt sein, beispielsweise eine allgemein als "Shunt" bezeichnete Schicht, welche auch einem Schutz der Supraleiterschicht vor Feuchtigkeit dienen kann. Es kann dann auch allgemein diese elektrisch leitende Deck- bzw. Umhüllungsschicht mit den die Kontaktstrecke und ggf. die Messtrecke ausbildenden Kontakten kontaktiert werden. Ein Shunt kann aber auch fehlen. Die Messkontakte 31, 32 sind mit Mitteln 35 zur Erfassung einer physikalischen Messgröße auf Basis des erzeugten Transportstromes in Bezug auf den kontaktierten Bandabschnitt signalübertragend verbunden, wobei der genannte Transportstrom über die elektrische Kontaktanordnung erzeugt wird. Die physikalische Messgröße ist hierbei derart ausgewählt, dass diese ein Maß für die supraleitenden elektrischen Transporteigenschaften bzw. für den tatsächlichen Transportstrom des Bandabschnittes oder eines Teiles desselben darstellen. Die Mittel 35 zur Erfassung der physikalischen Messgröße ihrerseits sind zur Übermittlung der Messgröße signalübertragend mit der Kontrolleinrichtung 10 verbunden. Wird somit beispielsweise stromgesteuert über die Kontaktstrecke ein Transportstrom in dem supraleitenden Bandabschnitt erzeugt, so kann als physikalische Messgröße der Spannungsabfall über die Messstrecke (Kontaktabstand 31, 32) erfasst werden. Wird der Transportstrom über die Kontaktstrecke spannungsgesteuert erzeugt, so kann die physikalische Messgröße der elektrische Transportstrom sein, welcher durch die Messstrecke der Kontakte 31, 32 fließt. Es versteht sich, dass der erzeugte Transportstrom jeweils durch eine andere geeignete physikalische Messgröße erfasst werden kann, beispielsweise einer von dem Transportstrom oder dem Spannungsabfall abgeleiteten physikalischen Größe, wie dem elektrischen Widerstand oder dergleichen.

Zur Durchführung des erfindungsgemäßen Verfahrens wird in dem kontinuierlich bewegten Band (d.h. der Supraleiterschicht desselben) ein Transportstrom erzeugt, welcher kontinuierlich oder schrittweise während der Bewegung des Bandes durch die Messstrecke in Bandlängsrichtung fortschreitet. Der Transportstrom wird somit im Rahmen der Erfindung vorzugsweise nicht zeitlich während der Bewegung des Bandes durch die Messstrecke unterbrochen, wobei das Band eine Länge aufweist, welche eine Vielzahl der gekühlten Bandabschnitte bzw. eine Vielzahl der Messstreckenlänge aufweist. Durch die Erfassung der physikalischen Messgröße bei währendem Bandtransport ist somit ein Qualitätssicherungsverfahren von HTS-Bändern geschaffen, welches einen hohen Banddurchsatz ermöglicht.

Allgemein im Rahmen des Ausführungsbeispiels kann der Transportstrom durch eine geregelte Spannung erzeugt werden, welche beispielsweise konstante oder sich zeitlich ändernd sein kann. Die weiteren Ausführungen im Hinblick auf den (idealisierten) Transportstrom gelten somit entsprechend für die geregelte Spannung zur Erzeugung des Transportstromes. Die Ausführungen beziehen sich allgemein - sofern nichts anderes gesagt - auf den idealisierten Transportstrom als Antwort auf die geregelte Spannung ohne Berücksichtigungen von Unregelmäßigkeiten in dem supraleitenden Material, welche zu nicht proportionalen Änderungen des Transportstromes mit der geregelten Spannung führen würden, oder auf den geregelten Transportstrom, wenn z.B. der Spannungsabfall als Mass für die Unregelmäßigkeiten des Supraleitermaterials gemessen wird.

Beispielsweise kann der der gemäß der Qualitätssicherung definierte einzuhaltende minimale kritische Transportstrom Ic(min) als Dauerstrom angelegt werden und über die als Spannungskontakte fungierenden Messkontakte der Spannungsabfall im bestromten Bandabschnitt gemessen und überprüft werden, dass dieser das Kriterium für Supraleitung erfüllt, beispielsweise bis zu 1 µV/cm beträgt. Bei Durchlaufen der Messstrecke kann in einer geeigneten Einrichtung wie der Kontrolleinrichtung 10 angezeigt und vorzugsweise zeitabhängig dokumentiert werden, ob zu dem jeweiligen Zeitpunkt der Verfahrensdurchführung das Qualitätskriterium im Hinblick auf den jeweils geforderten minimalen kritischen Transportstrom erfüllt ist. Alternativ und bevorzugt kann auch spannungsgeregelt eine Spannung angelegt werden, welche unter Berücksichtigung des zu erwartenden Sollwertes der elektrischen Leitfähigkeit des Supraleitermaterials einen entsprechenden Transportstrom erzeugt.

Weiterhin werden durch das erfindungsgemäße Verfahren und mittels der Vorrichtung etwaige lokale Fehlstellen, welche den kritischen Transportstrom der Supraleiterschicht des Bandes begrenzen, lokalisiert, und zwar mit einer Ortsauflösung, die genauer ist als die Länge der Kontakt- und/oder Messstrecke. Tritt eine derartige Fehlstelle bei transportiertem Band in die Kontaktstrecke, d.h. zwischen Einspeise- und Ableitungskontakt ein, so wird der supraleitende Transportstrom innerhalb der Supraleiterschicht mehr oder weniger stark abnehmen oder zusammenbrechen. Dies kann dann in der Messstrecke beispielsweise durch einen starken Spannungsanstieg (stromgeregelte Messung) oder einer starken Verminderung des Transportstromes (spannungsgeregelte Messung) erfasst und der Kontrolleinrichtung 10 zeitabhängig angezeigt und/oder gespeichert werden. Der in die Kontaktanordnung und/oder die Messstrecke eintretende Bereich des Supraleiterbandes bzw. der Supraleiterschicht kann dann durch geeignete Mittel 40 markiert werden oder dieser fehlstellenbehaftete Bereich kann durch Erfassen oder Festlegen der Bandgeschwindigkeit mittels der Einrichtung 50 über den Untersuchungszeitraum ab einem bestimmten Referenzpunkt und erfassen der Untersuchungszeit ab dem Referenzpunkt ermittelt werden. Allgemein kann die Markierung bei geeigneter Verfolgung der Bandstelle, z.B. bei bekannter Bandgeschwindigkeit und Verfahrdauer, auch außerhalb der Kühlstrecke erfolgen. Sind die Einspeisekontakte 21, 22 oder 22, 23 in Bandlängsrichtung beabstandet, so kann ferner ein Eintreten einer Fehlstelle jeweils in den Bereich zwischen diesen Kontakten durch die Messeinrichtung erfasst und die Signaländerung einschließlich Erfassung des Signalzeitpunktes an die Kontrolleinrichtung 10 gegeben werden, um in Kenntnis oder Bestimmung der Bandgeschwindigkeit die Fehlstelle lokalisieren zu können. Der fehlstellenbehaftete Bandbereich kann dann durch geeignete Maßnahmen, wie oben beschrieben, unter Herstellung der geforderten Supraleitung repariert werden. Es versteht sich, dass zur Erzielung einer ausreichend hohen Ortsauflösung die Kontaktstrecke und Messstrecke eine geeignete Länge aufweisen und in ihren Längen jeweils in geeigneter Weise aufeinander abgestimmt sind.

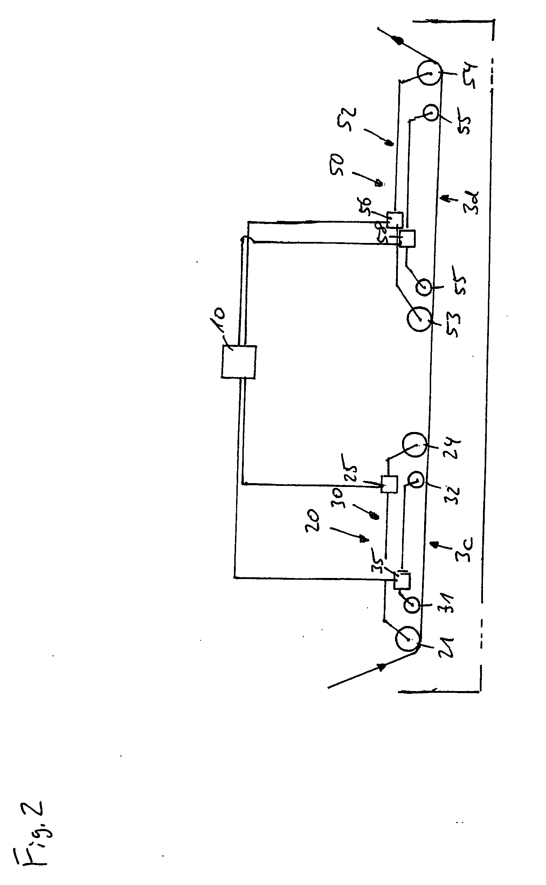

Weiterhin können gemäß Figur 2 an dem gekühlten Bandabschnitt weitere Kontaktstrecken 50 mit jeweils zugeordneten Messstrecken 52 (entsprechend den Kontakt- und Messstrecken wie oben ausgeführt) vorgesehen sein, welche unabhängig von der ersten Kontakt- und Messstrecke 20, 30 (mit Einspeise- und Ableitungskontakte 21, 24 und Messkontakte 31, 32) betreibbar sind und voneinander unabhängige Einspeise- und Ableitungskontakte 53, 54 und Messkontakte 55 aufweisen können und durch welche somit durch entsprechende Mittel 56 ein Transportstrom anderer Höhe und/oder mit unterschiedlichen Zeitabhängigkeiten bzw. Zeitprofilen in dem von dieser Kontaktstrecke kontaktierten Abschnitt 3d erzeugbar ist bzw. erzeugt wird, als in dem Bandabschnitt 3c, wobei die von diesem abhängig physikalische Messgröße in der Einrichtung 58 erfassbar ist. Hierdurch kann somit ermittelt und in der Kontrolleinrichtung 10 zeitabhängig erfasst werden, ob an einer ersten Kontaktanordnung 20 ein erster minimaler kritischer Transportstrom über die untersuchte Bandlänge eingehalten wird, wobei an einer zweiten Kontaktanordnung 50 ein von dem ersten Transportstrom verschiedener elektrischer Transportstrom Ic(min2) in dem Bandabschnitt 3d erzeugt werden kann, um zu überprüfen, ob eine zweite minimale kritische Stromstärke als Transportstrom, welche von der erstgenannten Stromstärke Ic(min1) verschieden ist. Durch den Bandtransport ist somit eine Untersuchung des gesamten Bandes möglich. Wie weiter unten ausgeführt ist, können aus einem elektrischen Transportstrom konstanter Höhe (oder möglichst konstanter Höhe) Transportwechselströme mit definiertem zeitabhängigen Wechselstromprofil erzeugt werden. Es können somit durch verschiedene Kontaktanordnungen an unterschiedlichen Bandbereichen Transportströme mit unterschiedlichen Zeitprofilen erzeugt werden, beispielsweise an einer ersten Kontaktanordnung ein Transportstrom konstanter Höhe, an einer weiteren Kontaktanordnung ein Transportstrom, welcher durch einen sinusförmigen Transportstrom von einer Frequenz F1 und einer Amplitude A1 überlagert ist, an einer weiteren Kontaktanordnung ein Transportstrom gleichmäßiger Höhe, welcher durch einen Transportwechselstrom mit Frequenz F2 und Amplitude A2 überlagert sein kann, wobei F1 ungleich F2 und/oder A1 ungleich A2 sein können, oder einen trapezförmigen Transportwechselstrom oder dergleichen. Hierdurch ist eine sehr detaillierte Qualitätskontrolle des Supraleiterbandes möglich. Die Transportwechselströme können hier jeweils stromgeregelt oder vorzugsweise spannungsgeregelt erzeugt werden.

Die Mittel 35, 58 zur Erfassung der physikalischen Messgröße sind somit derart ausgebildet und werden betrieben, dass diese praktisch kontinuierlich während der Bewegung des Bandes in Bandlängsrichtung die physikalische Messgröße erfassen, beispielsweise zeitlich ununterbrochen oder auch zeitgetaktet, sofern die Zeittaktung mit einer wesentlich größeren Geschwindigkeit erfolgt, als die Bandgeschwindigkeit, beispielsweise mit einem Faktor ≥ 2 - 4 oder ≥ 10 - 20 oder ≥ 50 - 100 oder ≥ 1.000 derselben. Das Band wird mittels der Transportmittel mit konstanter Bandgeschwindigkeit durch die Kontaktstrecke und/oder durch die Messstrecke oder während der Erfassung der physikalischen Messgröße bewegt.

Die Einspeise- und Ableitungskontakte 21-24 (und/oder gegebenenfalls die Messkontakte) können zugleich als Mittel zur Bewegung des Bandes ausgebildet sein und können hierzu reibschlüssig mit ihrem Umfang an dem Band ankoppeln, gegebenenfalls unter Anordnung von Gegenrollen auf der gegenüberliegenden Bandseite. Gegebenenfalls können allgemein auch separate oder zusätzliche Mittel zur Bewegung des Bandes wie z.B. Transportrollen vorgesehen sein. Das Band ist hier mäanderförmig um die Rollen 21-23 geschlungen, und kann linienförmig bzw. flächig an diesen anliegen. Zum Antrieb des Bandes weisen die Einspeise- und Ableitungskontakte die Antriebsmittel 6c und 6d auf.

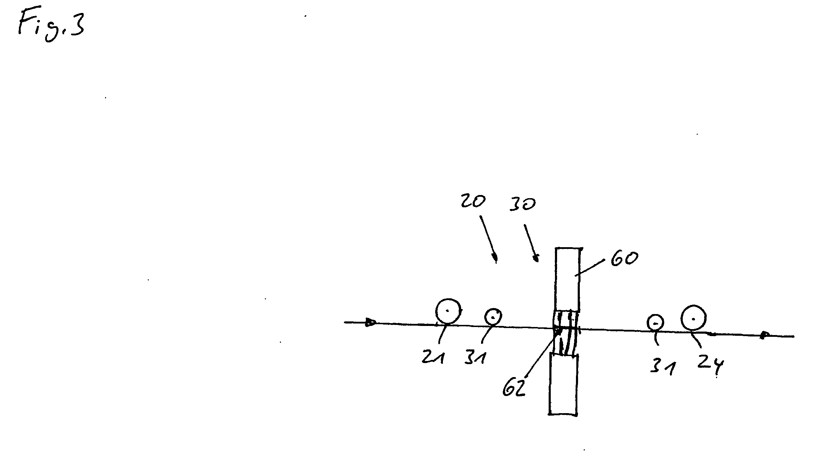

Figur 3 zeigt eine Weiterbildung der Vorrichtung nach den Figuren 1, 2 im Ausschnitt, die eine Einrichtung 60 zur Erzeugung eines stationären Magnetfeldes 61 in Form eines Permanentmagneten aufweist. Das hierdurch erzeugte Magnetfeld durchdringt das Supraleiterband 3 im Bereich der Kontakt- und/oder Messstrecke 20, 30 quer oder senkrecht zur Bandlängsrichtung bzw. zur Supraleiterschicht. Hierdurch wird der Transportstrom auf einen Querschnitt eingeschnürt, welcher kleiner als der geometrische Querschnitt der Supraleiterschicht des Bandes ist. Der stromeingeschnürte Bereich 62 der Supraleiterschicht bildet dann die eigentliche Messstrecke, da durch diesen der Transportstrom begrenzt wird. Die Einspeise-, Ableitungs- und Messkontakte 21, 24, 31, 32 sind somit außerhalb des Magnetfeldes angeordnet. Das Magnetfeld ist über dessen Erstreckung in Bandlängsrichtung homogen und kann eine Feldstärke von beispielsweise 0,001 bis 0,1 Tesla oder 0,05 bis 0,09 Tesla aufweisen, beispielsweise 0,025 T.

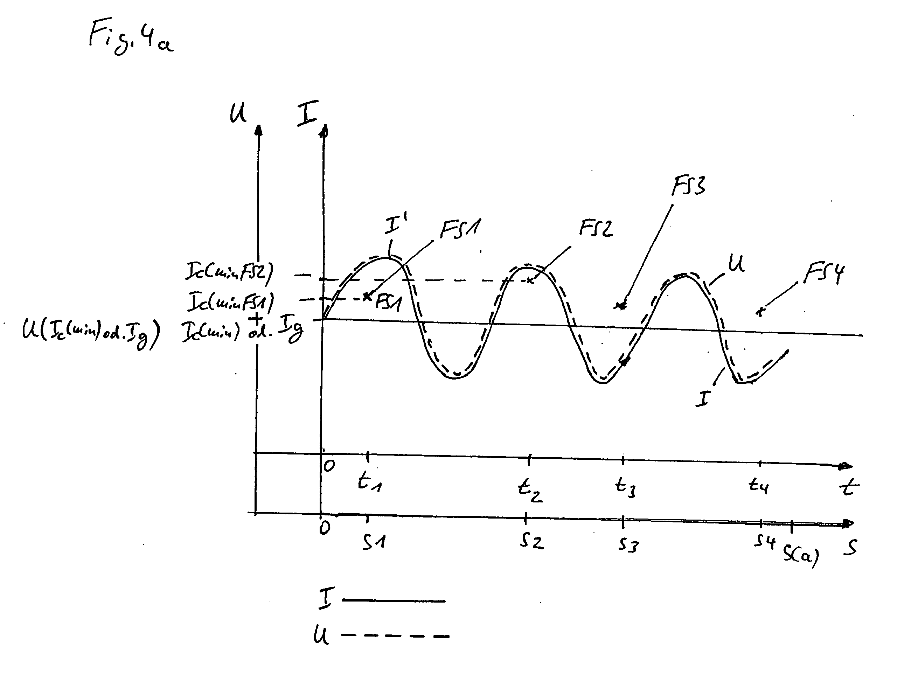

Figur 4a zeigt ein Diagramm eines Transportstroms (Grundstrom Ig) mit überlagerter Wechselstromkomponente I' über die Zeit t, also eine Art Modulation des Grundstromes, bei Anwesenheit von Fehlstellen FS in der Supraleiterschicht. Der Transportwechselstrom kann stromgeregelt oder insbesondere durch eine geregelte Spannung erzeugt werden, wobei für die Spannung die weiteren Ausführungen in Bezug auf den Wechselstrom entsprechend gelten, sofern nicht Unregelmäßigkeiten des supraleitenden Materials eine Korrelation der Spannung mit dem Transportwechselstrom stören, wie z.B. Fehlerstellen.

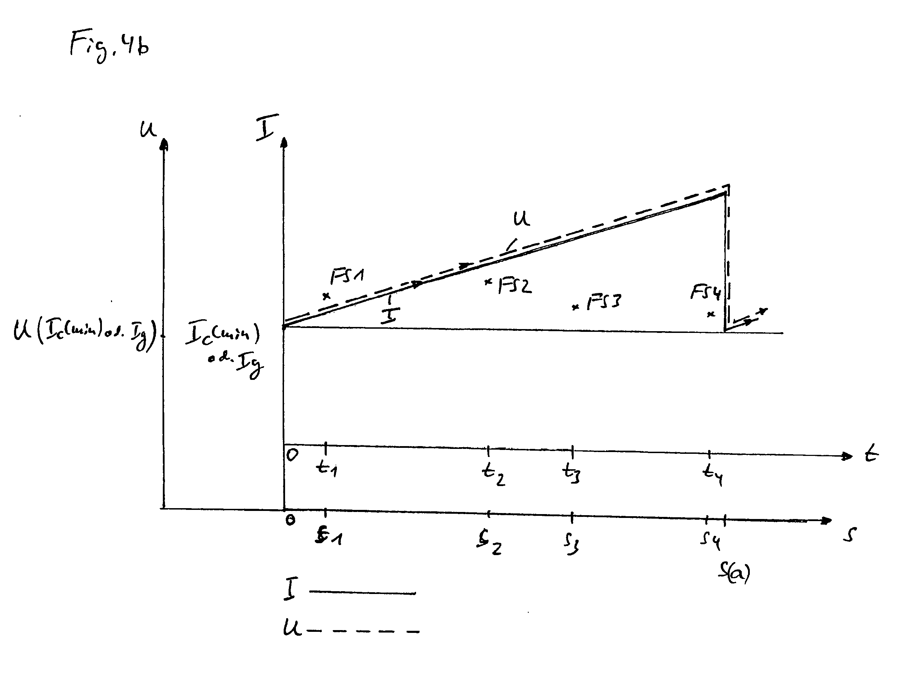

Die überlagerte Wechselstromkomponente I' bzw. die diese erzeugende Wechselspannungskomponente U' ist sinusförmig (die Skalierungen der U- und I-Achse sind unterschiedlich, um anzuzeigen, dass Spannung und erzeugter Strom korrelierren und die gleiche zeitabhängigkeit aufweisen). Die Frequenz der Wechselstromkomponente/Wechselspannungskomponente ist größer als der Quotient aus Bandgeschwindigkeit und Kontakt- oder Messstreckenlänge, die Amplitude A der Wechselstromkomponente ist (nicht zwingend) kleiner als die Höhe des Grundstromes Ig. Entsprechendes gilt für die erzeugende Wechselspannungskomponente in Bezug auf die Grundspannung. Erfasst eine lokale Fehlstelle FS1, FS2 eine Stromspitze des Wechselstromes, so wird der Transportstrom auf einen niedrigeren Wert begrenzt Ic(minFS1), Ic(minFS2), welcher jedoch höher als der minimale kritische Transportstrom Ic(min) (bzw. der angelegte Grundstrom Ig) sein kann, was zu einer entsprechenden Änderung der erfassten Messgröße führt. Je höher hier also der Wert "I" für die jeweilige Fehlstelle, desto geringer deren Störpotential in Bezug auf eine Begrenzung des Transportstromes. Über die ab einem vordefinierten Referenzpunkt des Bandes durchlaufene und erfasste Anzahl an Perioden des Transportwechselstromes bzw. die Zeit t1, t2 ist dann auch eine Ortsbestimmung der lokalen Fehlstelle an dem Band möglich. Aufgrund der gegebenen Bandgeschwindigkeit v sind dann die Fehlstellen ausgehend von dem Ort der Bandes s = 0 (Einlauf des Bandbereichs in die Kontakt- oder Messtrecke) zum Zeitpunkt t = 0 zum Zeitpunkt t1 bzw. t2 am Ort s1 oder s2 angeordnet. Die Fehlstellen FS3 und FS4 am Ort s3 oder s4 werden nicht detektiert. Hierdurch ist somit auch eine weitergehende Qualitätscharakterisierung des Bandes insgesamt möglich. Die Fehlstellen FS3 und FS4 werden hierbei durch die Wechselstromkomponente nicht erfasst. Das Verhältnis der Transportwechselstromfrequenz zu dem Verhältnis Bandgeschwindigkeit/Messstreckenlänge bzw. Bandgeschwindigkeit/Kontaktstreckenlänge kann hier z.B. ≥ 1, z.B. 2 - 5 oder mehr oder 10-50 betragen. Die Länge der Kontaktstrecke ist hierbei a bzw. der ort am Band mit Abstand a vom Referenzpunkt (t=0, s=0) ist s(a), wie auch in Fig. 4b.

Figur 4b zeigt ein Diagramm eines Transportstroms (Grundstrom Ig) mit überlagerter Wechselstromkomponente I' über die Zeit t entsprechend Fig. 4a, wobei die überlagerte "Wechselstromkomponente I'" hier eine Sägezahnform aufweist. Auch hier kann der Transportwechselstrom stromgeregelt oder insbesondere durch eine geregelte Spannung erzeugt werden, wobei im Übrigen auf das oben insbesondere zu Figur 4a Gesagte verwiesen wird. Die Frequenz der Wechselstromkomponente (bzw. Wechselspannungskomponente), d.h. der Anstieg der Rampe bis zum Maximalwert, kann hier gleich oder größer dem Quotienten aus Bandgeschwindigkeit und Kontakt- oder Messstreckenlänge sein, so dass z.B. über die jeweilige Länge des Bandabschnittes beim Durchlauf durch Kontakt- oder Messstrecke genau eine Rampe des I/t-Profils bzw. U/t-Profils gefahren wird. Auch hier kann gegebenenfalls das Verhältnis der Sägezahnfrequenz zu dem Verhältnis Bandgeschwindigkeit/Messstreckenlänge bzw. Bandgeschwindigkeit/Kontaktstreckenlänge z.B. ≥ 1 - 5 betragen, beispielsweise ca. 10 - 50. Bei einem Verhältnis von 1 wird somit beim Durchlaufen eines Bandabschnittes mit Länge der Kontakt- oder Messtrecke durch die eben die Kontakt- oder Messstrecke genau eine I/t-Rampe auf den Bandabschnitt aufgeprägt. Die Amplitude A der Wechselstromkomponente (Wechselspannungskomponente) ist auch hier (nicht zwingend) kleiner als die Höhe des Grundstromes Ig (Grundspannung Ug). Nach Figur 4b werden somit die Fehlstellen FS2, FS3 und FS4 detektiert, denen die Orte bzw. Abstände von der Nullstelle s2, s3, s4 bei bekannter Bandgeschwindigkeit v und Messung der Zeit t2, t3, t4 zugeordnet werden können, die Fehlstelle FS1 am Ort s1 jedoch nicht.

Ein besonderer Anwendungsfall ist gegeben, wenn die Spannungsregelung des Transportstromes derart durchgeführt wird, dass bei niedrigem Strom (niedriger eingestellter Spannung) das HTC-Material supraleitend und bei hohem Strom (hoher eingestellter Spannung) das HTC-Material normalleitend ist. Die den Tranportstrom erzeugende Wechselspannung kann z.B. ein Sinus- oder Sägezahnprofil aufweisen. Hierdurch kann z.B. der Übergangsbereich vom supraleitenden in den nicht-supraleitenden (normalleitenden) Zustand des supraleitenden Band bzw. insbesondere dessen Breite untersucht werden.

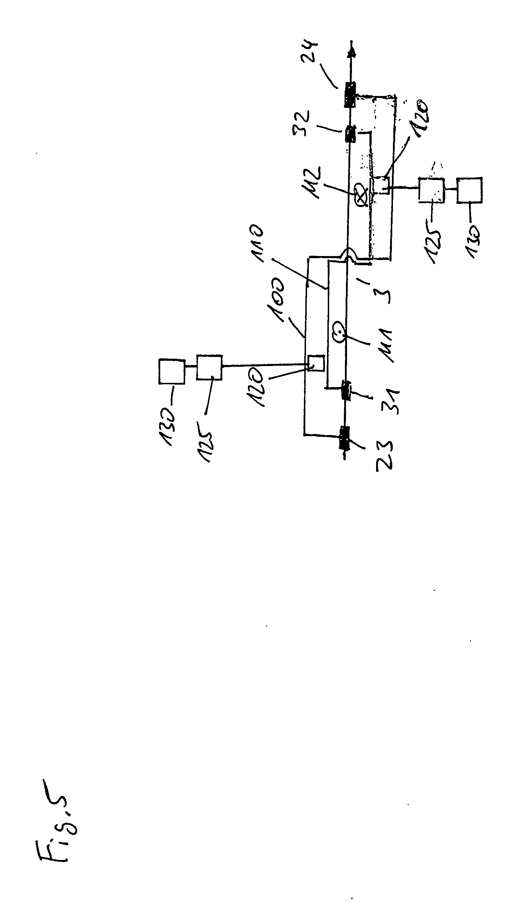

Figur 5 zeigt eine Weiterbildung der erfindungsgemäßen Vorrichtung in schematischer Draufsicht auf das Band 3. Zur möglichst genauen Bestimmung der kritischen Stromstärke Ic (min) mit Wechselstromkomponente bei der Messung werden die Einspeiseleitung 100 und die Messleitungen 110 zum Spannungsabgriff jeweils so geführt, dass die induktive Messspannung minimiert wird und die elektrischen Verbindungen zwischen dem Einspeise- und Ableitungskontakt 23, 24 der Kontaktanordnung und zwischen den beiden Messkontakten 31, 32 so geführt, dass diese auf beiden Seiten der Messstrecke gleich starke induzierte Magnetfelder M1 und M2 entgegen gesetzter Richtung erzeugen (also z.B. die durch die Leiter eingeschlossenen Flächen auf beiden Seiten des Bandes gleich groß sind). Weiterhin sind Kompensationsspulen 120 vorgesehen, welche Magnetfelder erzeugen, um die induktive Komponente des Messsignals zu minimieren, welche jeweils im Bereich der beiden Hälften von Kontakt- und Messstrecke angeordnet sein können. Die Einstellung der Magnetfeldstärke der Kompensationsspulen erfolgt mittels Ansteuerung 125 und zugeordnetem Rechner 130, wie oben beschrieben, welcher auch die induktive Komponente des Stromabfalls von dem Messsignal subtrahiert, wozu eine Mikrokontroller vorgesehen, z.B. in der Ansteuerung integriert, ist. Auch hier kann der Transportstrom stromgeregelt oder vorzugsweise spannungsgeregelt erzeugt werden.

## Patentansprüche

1. Verfahren zur Qualitätskontrolle von supraleitenden Bändern hinsichtlich der kritischen Strombelastbarkeit des Bandes, wobei das Band eine Länge 1 aufweist, mit den Schritten:
a) Kühlen eines Abschnittes des Supraleiterbandes auf eine Temperatur, bei welcher dieser Bandabschnitt supraleitend wird, wobei die Länge des Bandes ein Vielfaches der Bandabschnittslänge beträgt,
b) Erzeugen eines elektrischen Transportstromes in dem supraleitenden Bandabschnitt in Bandlängsrichtung unter kontaktieren mit einer Kontaktanordnung, welche in Bandlängsrichtung beabstandete elektrische Einspeise- und Ableitungskontakte aufweist, um zwischen diesen den Transportstrom mittels einer Transportstromerzeugungseinrichtung zu erzeugen,
c) Anordnen einer bezüglich des Transportstromes sensitiven Messanordnung an dem Band und/oder der Transportstromerzeugungseinrichtung,
d) kontinuierliche Bewegung zumindest eines Teiles des Bandes in Bandlängsrichtung durch die Kontaktstrecke und/oder durch die Messstrecke unter elektrischer Kontaktierung des bewegten Bandes zur Erzeugung eines in Bandlängsrichtung durch das Band fortschreitenden Transportstromes,
e) Erfassen einer physikalischen Messgröße auf Basis des erzeugten Transportstromes in Bezug auf die Messtrecke mittels der Messkontakte während der Bewegung zumindest eines Teiles des Bandes durch die Messstrecke, wobei die physikalische Messgröße ein Maß für die supraleitenden elektrischen Transporteigenschaften des Bandabschnittes oder eines Teiles des Bandes ist,
**dadurch gekennzeichnet, dass** der Transportstrom spannungsgeregelt erzeugt wird, wobei die den Transportstrom erzeugende Spannung auf einen konstanten Wert oder zeitabhängig geregelt wird.

2. Verfahren nach Anspruch 1, **dadurch gekennzeichnet, dass** in dem gekühlten Bandabschnitt ein elektrischer Transportstrom in Form eines Wechselstromes und/oder eine einen Transportwechselstrom erzeugende Wechselspannung erzeugt wird, dessen/deren Frequenz vorzugsweise größer/gleich dem Quotienten aus (i) der Bandgeschwindigkeit des bewegten Bandes und (ii) der Länge der Messtrecke in Bandlängsrichtung, welche jeweils dem gegebenen Bandabschnitt zugeordnet ist, und/oder der Länge der Kontaktstrecke, über welche der Transportstrom erzeugt wird, ist.

3. Verfahren nach einem der Ansprüche 1 oder 2, **dadurch gekennzeichnet, dass** der elektrische Transportwechselstrom dem konstanten oder sich zeitabhängig ändernden Transportstrom überlagert ist und dass die physikalische Messgröße auf Basis des resultierenden überlagerten Transportstromes erfasst wird.

4. Verfahren nach einem der Ansprüche 1 bis 3, **dadurch gekennzeichnet, dass** die Frequenz des erzeugten Transportwechselstromes und/oder der diesen erzeugenden Wechselspannung im Bereich von ca. 0,2 bis ca. 200 Hz liegt.

5. Verfahren nach einem der Ansprüche 1 bis 4, **dadurch gekennzeichnet, dass** das die Frequenz des erzeugten Transportwechselstromes und/oder der diesen erzeugenden Wechselspannung um den Faktor 1,01 bis 2.000 größer ist als der Quotient aus (i) der Bandgeschwindigkeit des bewegten Bandes und (ii) der Länge der Messtrecke in Bandlängsrichtung, welche jeweils dem gegebenen Bandabschnitt zugeordnet ist, und/oder der Länge der Kontaktstrecke, über welche der Transportstrom erzeugt wird.

6. Verfahren nach einem der Ansprüche 1 bis 5, **dadurch gekennzeichnet, dass** ein das supraleitende Band durchdringendes Magnetfeld erzeugt wird, durch welches der Transportstrom auf einem Querschnitt eingeschnürt wird, welcher kleiner als der geometrische Querschnitt der mit dem Transportstrom beaufschlagten supraleitenden Schicht des Bandes ist, und dass die physikalische Messgröße im Bereich des Bandes mit eingeschnürtem Transportstrom erfasst wird.

7. Verfahren nach einem der Ansprüche 1 bis 6, **dadurch gekennzeichnet, dass** die physikalische Messgröße kontinuierlich während der Bewegung des Bandes über eine Länge, die ein Vielfaches der Bandabschnittslänge beträgt, erfasst wird.

8. Verfahren nach einem der Ansprüche 1 bis 7, **dadurch gekennzeichnet, dass**
(i) mehrere elektrische Kontakte gleicher Polung als Einspeisekontakte gleichzeitig elektrisch kontaktierend an das Band angelegt werden, um zur Erzeugung eines elektrischen Transportstromes in dem Band mehrere Teilströme in das Band einzuspeisen
und/oder
(ii) dass zwei oder mehr Kontaktanordnungen zur Erzeugung jeweils eines Transportstromes in dem supraleitend gekühlten Band vorgesehen sind, mittels derer voneinander unabhängige Transportströme in dem jeweiligen gekühlten Bandabschnitt erzeugt werden, und dass die physikalische Messgröße in den verschiedenen Bereichen des Bandabschnittes unter Zuordnung zu den verschiedenen Transportströmen erfasst wird.

9. Verfahren nach einem der Ansprüche 1 bis 8, **dadurch gekennzeichnet, dass**
(i) das Verfahren im Übergangsbereich vom supraleitenden in den nicht-supraleitenden Zustand des supraleitenden Band durchgeführt wird,
und/oder
(ii) dass das Verfahren an einem supraleitenden Band durchgeführt wird, welches eine supraleitende Schicht aufweist, welche nicht mit einem elektrischen Shunt versehen ist, und/oder welches zumindest teilweise aus einem ferri- /ferromagnetischen Material besteht.

10. Vorrichtung zur Durchführung des Verfahrens nach einem der Ansprüche 1 bis 9 zur Qualitätskontrolle von supraleitenden Bändern, mit:
a) einer Kühlstrecke zur Kühlung eines Abschnittes des Bandes auf eine Temperatur, bei welcher dieser Bandabschnitt supraleitend wird, wobei die Länge des Bandes ein Vielfaches der Bandabschnittslänge beträgt,
b) einer Kontaktanordnung umfassend mehrere elektrische Kontakte zum Kontaktieren des gekühlten Bandabschnittes, wobei die elektrischen Kontakte zumindest einen Einspeisekontakt und zumindest einen Ableitungskontakt aufweisen, welche unter Ausbildung einer Kontaktstrecke in Bandlängsrichtung voneinander beabstandet sind,
c) einer Einrichtung zur Erzeugung eines elektrischen Transportstromes in dem kontaktierten Bandabschnitt vermittels des Einspeise- und Ableitungskontaktes, wobei zur Erzeugung des Transportstromes eine regelbare Spannungsquelle vorgesehen ist, die eingerichtet ist die den Transportstrom erzeugende Spannung auf einen konstanten Wert oder zeitabhängig, zu regeln.
d) einer Messanordnung zu Erfassung einer transportstromabhängigen physikalischen Größe, vorzugsweise umfassend zumindest zwei an dem mit dem Transportstrom beaufschlagten supraleitenden Bandabschnitt anlegbaren, in Bandlängsrichtung voneinander beabstandeten Messkontakten, die an der Kontaktanordnung vorgesehen sind, und die eine Messstrecke über die Länge oder eine Teillänge des mit dem Transportstrom beaufschlagten Bandabschnittes ausbilden,
e) Mittel zur Bewegung zumindest eines Teil des Bandes in Bandlängsrichtung durch die Kontaktstrecke unter kontinuierlicher elektrischer Kontaktierung des bewegten Bandes, wobei die Mittel geeignet sind, einen in Bandlängsrichtung durch das Band fortschreitenden Transportstrom zu erzeugen, und
f) Mittel zur Erfassung einer physikalischen Messgröße auf Basis des in dem Bandabschnitt erzeugten Transportstromes mittels der Messkontakte während einer Bewegung zumindest eines Teiles des Bandes durch die Messstrecke, wobei die physikalische Messgröße derart ausgewählt ist, dass diese ein Maß für die supraleitenden elektrischen Transporteigenschaften des Bandabschnittes oder eines Teiles des Bandes ermöglichen.

11. Vorrichtung nach Anspruch 10, **dadurch gekennzeichnet, dass**
(i) die Mittel zur Bewegung des Bandes Mitnehmer aufweisen, welche zur reibschlüssigen Ankoppelung an das Band ausgebildet sind oder reibschlüssig an dem Band ankoppeln, um dieses durch die Messstrecke zu bewegen und/oder das Band während dessen Bewegung mit einer definierten Vorspannung zu beaufschlagen,
und/oder
(ii) dass die elektrische Kontaktanordnung mehrere elektrische Kontakte gleicher Polung umfasst, welche gleichzeitig elektrisch kontaktierend an das Band anlegbar sind, um einen oder mehrere unabhängige elektrische Transportströme in dem Band zu erzeugen.

12. Vorrichtung nach einem der Ansprüche 10 bis 11, **dadurch gekennzeichnet, dass** die Kontaktanordnung mehr als zwei Einspeisekontakte aufweist, welche jeweils einem gemeinsamen Ableitungskontakt zugeordnet sind, und dass die Kontakte derart angeordnet sind, dass gleichzeitig in verschiedenen Bereichen des gekühlten Bandabschnittes mehrere Transportströme unterschiedlicher Stromstärke erzeugbar sind und dass die Einrichtung zur Erfassung der physikalischen Messgröße derart ausgebildet ist, dass die physikalische Messgröße in den verschiedenen Bereichen des Bandabschnittes mit unterschiedlicher Transportstromstärke unter Zuordnung zu diesen Bandabschnitten erfassbar ist.

13. Vorrichtung nach einem der Ansprüche 10 bis 12, **dadurch gekennzeichnet, dass**
(i) die Mittel zur Erzeugung des Transportstromes ausgebildet sind, um einen konstanten oder sich zeitabhängig ändernden Transportstrom zu erzeugen,
und/oder
(ii) dass die Mittel zur Erzeugung des Transportstromes derart ausgebildet sind, dass diese in dem gekühlten Bandabschnitt einen Transportstrom in Form eines Wechselstromes erzeugen.

14. Vorrichtung nach einem der Ansprüche 10 bis 13, **dadurch gekennzeichnet, dass** die Mittel zur Erzeugung des Transportstromes derart ausgebildet sind, dass in dem Band ein Transportstrom in Form eines Wechselstromes erzeugbar ist, welcher vorzugsweise in demselben Bandabschnitt zeitgleich mit einem Transportstrom konstanter oder sich gleichmäßig ändernder Transportstromstärke erzeugbar ist, und dass die Mittel zur Erfassung der physikalischen Messgröße ausgebildet sind, um die aus dem Transportwechselstrom oder aus dem überlagerten Transportstrom resultierende physikalische Messgröße zu erfassen.

15. Vorrichtung nach einem der Ansprüche 10 bis 14, **dadurch gekennzeichnet, dass** die Mittel zur Erzeugung des Transportstromes in Form eines Wechselstromes derart ausgebildet sind, dass ein Wechselstrom und/oder eine Wechselspannung mit einer Frequenz im Bereich von ca. 0,2 bis ca. 200 Hz erzeugbar ist.

## Claims

1. A method for the quality control of superconducting tapes in respect of the critical current-carrying capacity of the tape, with the tape having a length 1, comprising the steps of:
a) cooling a portion of the superconducting tape to a temperature at which this tape portion becomes superconducting, with the length of the tape being a multiple of the length of the tape portion,
b) generating an electric transport current in the superconducting tape portion in the length direction of the tape so as to make contact with a contact arrangement which has electrical feed contacts and discharge contacts which are spaced apart in the length direction of the tape, in order to generate the transport current between said contacts by means of a transport current generating device,
c) arranging a measurement arrangement, which is sensitive with respect to the transport current, on the tape and/or on the transport current generating device,
d) continuously moving at least part of the tape in the length direction of the tape through the contact section and/or through the measurement section so as to make electrical contact with the moving tape for the purpose of generating a transport current which advances through the tape in the length direction of the tape,
e) detecting a physical measurement variable on the basis of the generated transport current in relation to the measurement section by means of the measurement contacts during the movement of at least part of the tape through the measurement section, with the physical measurement variable being a measure of the superconducting electrical transport properties of the tape portion or part of the tape,
wherein the transport current is generated in a voltage-controlled manner, with the voltage which generates the transport current being adjusted to a constant value or in a time-dependent manner.

2. The method according to claim 1, wherein an electric transport current in the form of an alternating current and/or an AC voltage which generates an alternating transport current is generated in the cooled tape portion, the frequency of said alternating current or AC voltage preferably being greater than/equal to the quotient of (i) the tape speed of the moving tape and (ii) the length of the measurement section in the length direction of the tape, which length direction is associated in each case with the tape portion in question, and/or the length of the contact section over which the transport current is generated.

3. The method according to either of claims 1 and 2, wherein the electric alternating transport current is superimposed on the constant transport current or the transport current which changes in a time-dependent manner, and wherein the physical measurement variable is detected on the basis of the resulting superimposed transport current.

4. The method according to one of claims 1 to 3, wherein the frequency of the generated alternating transport current and/or the AC voltage which generates said alternating transport current is in the range of from approximately 0.2 to approximately 200 Hz.

5. The method according to one of claims 1 to 4, wherein the frequency of the generated alternating transport current and/or the AC voltage which generates said alternating transport current is greater by a factor of 1.01 to 2000 than the quotient of (i) the tape speed of the moving tape and (ii) the length of the measurement section in the length direction of the tape, which length direction is associated in each case with the tape portion in question, and/or the length of the contact section over which the transport current is generated.

6. The method according to one of claims 1 to 5, wherein a magnetic field which penetrates the superconducting tape is generated, said magnetic field restricting the transport current to a cross section which is smaller than the geometric cross section of the superconducting layer of the tape to which the transport current is applied, and wherein the physical measurement variable is detected in the region of the tape with a restricted transport current.

7. The method according to one of claims 1 to 6, wherein the physical measurement variable is detected continuously during the movement of the tape over a length which is a multiple of the length of the tape portion.

8. The method according to one of claims 1 to 7,
(i) wherein a plurality of electrical contacts with the same polarity are fitted to the tape, so as to make electrical contact in a simultaneous manner, as feed contacts in order to feed a plurality of partial currents into the tape for the purpose of generating an electric transport current,
and/or
(ii) wherein two or more contact arrangements for generating in each case one transport current in the superconducting cooled tape are provided, transport currents which are independent of one another being generated in the respective cooled tape portion by means of said contact arrangements, and wherein the physical measurement variable is detected in the various regions of the tape portion with assignment to the different transport currents.

9. The method according to one of claims 1 to 8,
(i) wherein the method is carried out in the transition region from the superconducting state of the superconducting tape to the non-superconducting state of the superconducting tape,
and/or
(ii) wherein the method is carried out on a superconducting tape which has a superconducting layer which is not provided with an electrical shunt, and/or which superconducting tape is at least partially composed of a ferrimagnetic/ferromagnetic material.

10. An apparatus for carrying out the method according to one of claims 1 to 9 for the quality control of superconducting tapes, comprising:
a) a cooling section for cooling a portion of the tape to a temperature at which this tape portion becomes superconducting, with the length of the tape being a multiple of the length of the tape portion,
b) a contact arrangement comprising a plurality of electrical contacts for making contact with the cooled tape portion, with the electrical contacts having at least one feed contact and at least one discharge contact which are spaced apart from one another in the length direction of the tape so as to form a contact section,
c) a device for generating an electric transport current in the tape portion with which contact is made, by means of the feed contact and discharge contact, with an adjustable voltage source being provided for the purpose of generating the transport current, said voltage source being designed to adjust the voltage which generates the transport current to a constant value or in a time-dependent manner,
d) a measurement arrangement for detecting a transport-current-dependent physical variable, preferably comprising at least two measurement contacts, which can be fitted to the superconducting tape portion to which the transport current is applied, which are spaced apart from one another in the length direction of the tape, which are provided on the contact arrangement, and which form a measurement section over the length or a partial length of the tape portion to which the transport current is applied,
e) means for moving at least part of the tape in the length direction of the tape through the contact section so as to make continuous electrical contact with the moving tape, wherein the means are suitable for generating a transport current which advances through the tape in the length direction of the tape, and
f) means for detecting a physical measurement variable on the basis of the transport current, which is generated in the tape portion, by means of the measurement contacts during a movement of at least part of the tape through the measurement section, with the physical measurement variable being selected in such a way that it is a measure of the superconducting electrical transport properties of the tape portion or part of the tape.

11. The apparatus according to claim 10, wherein
(i) the means for moving the tape have drivers which are designed to be coupled to the tape with a friction fit or are coupled to the tape with a friction fit in order to move said tape through the measurement section and/or to subject the tape to the action of a defined pretension during the movement of said tape,
and/or
(ii) wherein the electrical contact arrangement comprises a plurality of electrical contacts of the same polarity which can be fitted to the tape so as to make electrical contact in a simultaneous manner in order to generate one or more independent electric transport currents in the tape.

12. The apparatus according to either of claims 10 and 11, wherein the contact arrangement has more than two feed contacts which are each associated with a common discharge contact, and wherein the contacts are arranged in such a way that a plurality of transport currents of different currents can be generated in different regions of the cooled tape portion at the same time, and wherein the device for detecting the physical measurement variable is designed in such a way that the physical measurement variable can be detected in the various regions of the tape portion with different transport currents with assignment to said tape portions.

13. The apparatus according to one of claims 10 to 12, wherein
(i) the means for generating the transport current are designed in order to generate a constant transport current or a transport current which changes in a time-dependent manner,
and/or
(ii) wherein the means for generating the transport current are designed in such a way that they generate a transport current in the form of an alternating current in the cooled tape portion.

14. The apparatus according to one of claims 10 to 13, wherein the means for generating the transport current are designed in such a way that a transport current in the form of an alternating current can be generated in the tape, it preferably being possible to generate said transport current in the same tape portion at the same time as a constant transport current or a transport current which changes uniformly, and wherein the means for generating the physical measurement variable are designed in order to detect the physical measurement variable resulting from the alternating transport current or from the superimposed transport current.

15. The apparatus according to one of claims 10 to 14, wherein the means for generating the transport current are designed in the form of an alternating current in such a way that an alternating current and/or an AC voltage with a frequency in the range of from approximately 0.2 to approximately 200 Hz can be generated.

## Revendications

1. Procédé de contrôle de qualité de bandes supraconductrices par rapport à la capacité de charge de courant critique de la bande, la bande présentant une longueur 1, avec les étapes suivantes :
a) refroidissement d'une section de la bande supraconductrice à une température à laquelle cette section de bande devient supraconductrice, la longueur de la bande étant un multiple de la longueur de section de bande ;
b) production d'un courant de transport électrique dans la section de bande supraconductrice dans la direction longitudinale de bande par mise en contact avec un agencement de contact comportant des contacts d'alimentation et de dérivation électriques espacés dans la direction longitudinale de bande, pour produire entre eux le courant de transport à l'aide d'un dispositif de production de courant de transport ;
c) mise en place d'un agencement de mesure sensitif par rapport au courant de transport au niveau de la bande et/ou du dispositif de production de courant de transport ;
d) déplacement continu d'au moins une partie de la bande dans la direction longitudinale de bande au travers du tronçon de contact et/ou au travers du tronçon de mesure par mise en contact électrique de la bande déplacée pour produire un courant de transport progressant dans la direction longitudinale de bande ;
e) détection d'une grandeur de mesure physique sur la base du courant de transport produit par rapport au tronçon de mesure à l'aide des contacts de mesure pendant le déplacement d'au moins une partie de la bande au travers du tronçon de mesure, la grandeur de mesure physique étant une mesure des propriétés de transport électrique supraconductrices de la section de bande ou d'une partie de la bande ;
**caractérisé en ce que** le courant de transport est produit par régulation de tension, la tension produisant le courant de transport étant réglée sur une valeur constante ou en fonction de l'heure.

2. Procédé selon la revendication 1, **caractérisé en ce qu'**un courant de transport électrique est produit sous la forme d'un courant alternatif et/ou d'une tension alternative produisant un courant alternatif de transport dans la section de bande refroidie, dont la fréquence est de préférence supérieure ou égale au quotient composé (i) de la vitesse de bande de la bande déplacée et (ii) de la longueur du tronçon de mesure dans la direction longitudinale de bande respectivement associée à la section de bande donnée et/ou de la longueur du tronçon de contact sur lequel le courant de transport est produit.

3. Procédé selon l'une quelconque des revendications 1 ou 2, **caractérisé en ce que** le courant alternatif de transport électrique est superposé au courant de transport constant ou variable dans le temps et que la grandeur de mesure physique est détectée sur la base du courant de transport superposé résultant.

4. Procédé selon l'une quelconque des revendications 1 à 3, **caractérisé en ce que** la fréquence du courant alternatif de transport produit et/ou de la tension alternative le produisant se situe dans la plage allant d'environ 0,2 à environ 200 Hz.

5. Procédé selon l'une quelconque des revendications 1 à 4, **caractérisé en ce que** la fréquence du courant alternatif de transport produit et/ou de la tension alternative le produisant est supérieure d'un facteur 1,01 à 2 000 au quotient composé (i) de la vitesse de bande de la bande déplacée et (ii) de la longueur du tronçon de mesure dans la direction longitudinale de bande respectivement associée à la section de bande donnée et/ou de la longueur du tronçon de contact sur laquelle le courant de transport est produit.

6. Procédé selon l'une quelconque des revendications 1 à 5, **caractérisé en ce qu'**un champ magnétique traversant la bande supraconductrice est produit à travers lequel le courant de transport est comprimé pour atteindre une section transversale inférieure à la section transversale géométrique de la couche supraconductrice de la bande alimentée en courant de transport et que la grandeur de mesure physique est détectée dans la région de la bande présentant un courant de transport comprimé.

7. Procédé selon l'une quelconque des revendications 1 à 6, **caractérisé en ce que** la grandeur de mesure physique est détectée en continu pendant le déplacement de la bande sur une longueur représentant un multiple de la longueur de section de bande.

8. Procédé selon l'une quelconque des revendications 1 à 7, **caractérisé en ce que** :
(i) plusieurs contacts électriques de même polarisation sont placés contre la bande entrant simultanément en contact électrique sous la forme de contacts d'alimentation, afin de produire un courant de transport électrique prévu dans la bande alimentant plusieurs courants partiels prévus dans la bande ;
et/ou
(ii) deux agencements de contact ou plus sont prévus pour produire respectivement un courant de transport dans la bande refroidie supraconductrice, à l'aide desquels des courants de transport indépendants l'un de l'autre sont produits dans la section de bande refroidie respective et que la grandeur de mesure physique est détectée dans les différentes zones de la section de bande en association avec les différents courants de transport.

9. Procédé selon l'une quelconque des revendications 1 à 8, **caractérisé en ce que** :
(i) le procédé est mis en oeuvre dans la zone de transition allant de l'état supraconducteur à l'état non supraconducteur de la bande supraconductrice ; et/ou
(ii) le procédé est mis en oeuvre au niveau d'une bande supraconductrice comportant une couche supraconductrice non pourvue d'un shunt électrique et/ou composée au moins en partie d'un matériau ferri/ferromagnétique.

10. Dispositif de réalisation d'un procédé selon l'une quelconque des revendications 1 à 9, pour effectuer un contrôle de qualité de bandes supraconductrices, avec :
a) un tronçon de refroidissement servant à refroidir une section de la bande à une température à laquelle cette section de bande devient supraconductrice, la longueur de la bande étant un multiple de la longueur de section de bande ;
b) un agencement de contact comprenant plusieurs contacts électriques pour la mise en contact de la section de bande refroidie, les contacts électriques comportant au moins un contact d'alimentation et au moins un contact de dérivation espacés l'un par rapport à l'autre dans la direction longitudinale de bande par formation d'un tronçon de contact ;
c) un dispositif de production d'un courant de transport électrique dans la section de bande contactée à l'aide du contact d'alimentation et de dérivation, une source de tension réglable étant prévue pour produire le courant de transport, ladite source étant conçue pour régler la tension produisant le courant de transport sur une valeur constante ou en fonction de l'heure ;
d) un agencement de mesure pour détecter une grandeur physique dépendant du courant de transport, comprenant de préférence au moins deux contacts de mesure pouvant être placés contre la section de bande supraconductrice alimentée en courant de transport espacés l'un par rapport à l'autre dans la direction longitudinale de bande et prévus au niveau de l'agencement de contact et formant un tronçon de mesure sur toute la longueur ou sur une longueur partielle de la section de bande alimentée en courant de transport ;
e) des moyens de déplacement d'au moins une partie de la bande dans la direction longitudinale de bande à travers le tronçon de contact par mise en contact électrique continue de la bande déplacée, les moyens étant adaptés pour produire un courant de transport dans la direction longitudinale de bande progressant à travers la bande ; et
f) des moyens de détection d'une grandeur de mesure physique sur la base du courant de transport produit dans la section de bande à l'aide des contacts de mesure pendant un déplacement d'au moins une partie de la bande au travers du tronçon de mesure, la grandeur de mesure physique étant choisie de telle sorte qu'elle est une mesure des propriétés de transport électrique supraconductrices de la section de bande ou d'une partie de la bande.

11. Dispositif selon la revendication 10, **caractérisé en ce que** :
(i) les moyens de déplacement de la bande comportent des éléments d'entraînement réalisés au niveau de la bande pour réaliser un couplage par complémentarité de frottements ou pour être couplés à la bande par complémentarité de frottements, en vue de la déplacer au travers du tronçon de mesure et/ou pour charger la bande avec une précontrainte définie pendant son déplacement ;
et/ou
(ii) l'agencement de contact électrique comprend plusieurs contacts électriques de même polarisation pouvant être appliqués simultanément par mise en contact électrique au niveau de la bande, pour produire un ou plusieurs courants de transport électriques indépendants dans la bande.

12. Dispositif selon l'une quelconque des revendications 10 à 11, **caractérisé en ce que** l'agencement de contact comporte plus de deux contacts d'alimentation respectivement associés à un contact de dérivation commun et que les contacts sont disposés de telle sorte que plusieurs courants de transport peuvent produire différentes puissances de courant simultanément dans différentes zones de la section de bande refroidie et que le dispositif de détection de la grandeur de mesure physique est réalisé de telle sorte que la grandeur de mesure physique peut être détectée dans les différentes zones de la section de bande avec différentes puissances de courant de transport en association avec ces sections de bande.

13. Dispositif selon l'une quelconque des revendications 10 à 12, **caractérisé en ce que** :
(i) les moyens de production du courant de transport sont réalisés pour produire un courant de transport constant ou variant en fonction de l'heure ; et/ou
(ii) les moyens de production du courant de transport sont réalisés de telle sorte qu'ils produisent un courant de transport sous la forme d'un courant alternatif dans la section de bande refroidie.

14. Dispositif selon l'une quelconque des revendications 10 à 13, **caractérisé en ce que** les moyens de production du courant de transport sont réalisés de telle sorte qu'un courant de transport peut être produit dans la bande sous la forme d'un courant alternatif, ledit courant pouvant de préférence être produit dans la même section de bande simultanément avec un courant de transport de puissance de courant de transport constante ou variant de façon constante et que les moyens de détection de la grandeur de mesure physique sont réalisés pour détecter la grandeur de mesure physique résultant du courant alternatif de transport ou du courant de transport superposé.

15. Dispositif selon l'une quelconque des revendications 10 à 14, **caractérisé en ce que** les moyens de production du courant de transport sont réalisés sous la forme d'un courant alternatif de telle sorte qu'un courant alternatif et/ou une tension alternative peuvent être produits à une fréquence située dans la plage allant d'environ 0,2 à environ 200 Hz.
